# FASCICULE DE BREVET EUROPEEN

(11) **EP 2 137 873 B1**
(45) Date de publication et mention de la délivrance du brevet: **09.07.2014**
(21) Numéro de dépôt: 08787918.5
(22) Date de dépôt: 04.04.2008
(51) Int. Cl.: H04L 7/027, H04L 7/033, H03L 7/24

(54) **DISPOSITIF D'EXTRACTION D'HORLOGE A ASSERVISSEMENT NUMERIQUE DE PHASE SANS REGLAGE EXTERNE**
VORRICHTUNG ZUR RÜCKGEWINNUNG DES TAKTSIGNALES ZUR DIGITALEN REGELUNG DER PHASE OHNE EXTERNE REGELUNG
CLOCK EXTRACTION DEVICE WITH DIGITAL PHASE LOCK, REQUIRING NO EXTERNAL CONTROL

(30) Priorité: 06.04.2007 FR 0702552
(43) Date de publication de la demande: 30.12.2009
(73) Titulaire: Centre National d'Etudes Spatiales (C.N.E.S.), 75039 Paris Cedex 01 (FR)
(72) Inventeur: PIGNOL, Michel, F-31000 Toulouse (FR); NEVEU, Claude, F-31600 Saint Clar de Rivière (FR); DEVAL, Yann, F-33800 Bordeaux (FR); BEGUERET, Jean-Baptiste, F-33400 Talence (FR); MAZOUFFRE, Olivier, F-33360 Latresne (FR)
(74) Mandataire: Cabinet BARRE LAFORGUE & associés
(86) Numéro de dépôt international: PCT/FR2008/000479
(87) Numéro de publication internationale: WO 2008/139064

(56) Documents cités:
- FR-A- 2 838 265
- US-A- 3 609 408
- US-A- 4 059 812
- US-A- 5 671 259
- NG H-T ET AL: "A SECOND-ORDER SEMIDIGITAL CLOCK RECOVERY CIRCUIT BASED ON INJECTION LOCKING" IEEE JOURNAL OF SOLID-STATE CIRCUITS, IEEE SERVICE CENTER, PISCATAWAY, NJ, US, vol. 38, no. 12, décembre 2003 (2003-12), pages 2101-2110, XP001221460 ISSN: 0018-9200
- JEN S H-M ET AL: "A Single-Chip Dual-Band Tri-Mode CMOS Transceiver for IEEE 802.11a/b/g Wireless LAN" IEEE JOURNAL OF SOLID-STATE CIRCUITS, IEEE SERVICE CENTER, PISCATAWAY, NJ, US, vol. 39, no. 12, décembre 2004 (2004-12), pages 2239-2249, XP011122660 ISSN: 0018-9200
- ALEXANDER J D H: "CLOCK RECOVERY FROM RANDOM BINARY SIGNALS" ELECTRONICS LETTERS, IEE STEVENAGE, GB, vol. 11, no. 22, 30 octobre 1975 (1975-10-30), pages 541-542, XP001000516 ISSN: 0013-5194 cité dans la demande

## Description

L'invention concerne un dispositif d'extraction d'horloge, et plus particulièrement un dispositif d'extraction d'horloge et de données numériques, à partir d'un signal série en bande de base, dit signal reçu, représentatif de données numériques, et codé avec un signal d'horloge présentant une fréquence d'horloge bits fsr correspondant au moins sensiblement à une fréquence nominale fn.

Dans de nombreuses applications, et en particulier dans le domaine des très hautes fréquences (fréquences nominales fn supérieures à 500 MHz, pouvant être supérieures à 10 GHz, pouvant aller actuellement jusqu'à 40 GHz et même dépasser très largement ces valeurs dans le futur) correspondant à des très hauts débits (supérieurs à 500 Mbits/s, pouvant être supérieurs à 10 Gbits/s, et pouvant aller jusqu'à 40 Gbits/s pour les standards SONET OC-768 et SDH STM-256 et pouvant dépasser très largement ces valeurs dans le futur), on transmet sur un canal de transmission (dont la technologie de réalisation peut être quelconque : électrique, optique, radiofréquence,...) d'une liaison série en bande de base un signal incorporant des données numériques mixées avec un signal d'horloge, de façon à éviter d'avoir à transmettre ces deux informations sur deux canaux différents. Ceci permet d'éviter tout appairage délicat de la longueur des cheminements des signaux. Avec de tels signaux, au niveau du récepteur, il est nécessaire d'extraire du signal reçu, de nature analogique, d'une part les valeurs des données numériques et, d'autre part, le signal d'horloge correspondant à ces données. Pour obtenir les valeurs des données, on échantillonne le signal reçu à partir du signal d'horloge préalablement extrait des données.

La solution la plus usuelle pour réaliser un tel dispositif d'extraction d'horloge et de données consiste à utiliser des circuits comprenant au moins une boucle à verrouillage de phase, dite PLL, qui comprend principalement, à la sortie d'un circuit générant des impulsions correspondant aux fronts montants et descendants du signal reçu, un comparateur de phase délivrant un signal de consigne à un oscillateur contrôlé en tension, dit VCO, via un filtre de boucle. Le VCO fournit un signal d'horloge interne à une bascule de décision, constituant un circuit d'échantillonnage qui extrait les données du signal reçu. Ces circuits PLL traditionnels, qui utilisent des oscillateurs à relaxation ou des oscillateurs à réseau LC, des comparateurs phase/fréquence et des diviseurs numériques haute fréquence, présentent divers inconvénients. Ils sont incompatibles avec des liaisons à très haut débit ; nécessitent une référence de fréquence externe ; nécessitent une synchronisation au démarrage par un préambule de données devant nécessairement être présent dans le signal reçu, ce qui n'est pas admissible dans certaines applications ; présentent une grande complexité d'optimisation de fonctionnement et de réalisation, de nombreux paramètres interdépendants et contradictoires devant être pris en compte, notamment en ce qui concerne le circuit comparateur phase/fréquence ; ont une consommation énergétique très importante ; leur réalisation analogique est fortement dépendante de la technologie de fabrication des composants semiconducteurs mise en oeuvre... En conséquence, la réalisation d'un circuit PLL pour réaliser une fonctionnalité d'extraction d'horloge nécessite l'intervention de spécialistes des circuits analogiques ayant une grande expérience et un grand savoir-faire, et, d'autre part, nécessite des durées de développement importantes, à renouveler régulièrement à chaque évolution de la technologie, ce qui, du point de vue des contraintes actuelles d'exploitation à l'échelle industrielle, n'est pas admissible.

Une autre solution connue pour réaliser l'extraction d'horloge est fondée sur l'utilisation d'une boucle à verrouillage de délais, dite DLL. Ces circuits nécessitent cependant un code spécifique en ce qui concerne le signal reçu, en particulier avec un bit de démarrage et un bit de stop pour former une transition de référence dans chaque mot (ce qui réduit la fréquence de transmission maximale accessible pour les données, typiquement de 33 % avec des données utiles sur 8 bits et un code tel que le 8B/12B). En outre, les données récupérées présentent une dérive de phase (« jitter ») relativement importante, pouvant conduire à un taux d'erreurs de bits non négligeable. Également, un tel circuit DLL est très sensible aux bruits sur le signal reçu. Enfin, cette technique mise en oeuvre par des composants numériques est difficilement compatible avec des vitesses de transmission extrêmement élevées.

FR 2838265 a proposé une solution consistant à utiliser un oscillateur à injection, c'est-à-dire un oscillateur verrouillé en injection sur la fréquence de fronts du signal reçu dans un circuit en boucle ouverte. Pour ce faire, l'oscillateur à injection est un oscillateur à résistances négatives utilisant une paire couplée de transistors MOS, et reçoit un signal d'impulsions de synchronisation cadencé à la fréquence d'horloge bits fsr du signal reçu, ce signal d'impulsion étant émis par un générateur d'impulsions de synchronisation. Cet oscillateur verrouillé en injection présentant une fréquence d'oscillations libres fos, a la faculté de se verrouiller sur le signal d'impulsions si la fréquence de ce dernier est dans sa plage de fonctionnement, dite plage de capture. Il fournit alors un signal d'horloge dont la fréquence correspond exactement à la fréquence d'horloge bits fsr.

Néanmoins, le problème qui se pose alors est d'assurer aussi la synchronisation en phase du signal d'horloge fourni par l'oscillateur, par rapport au signal reçu. À ce titre, on sait que le décalage de phase introduit par l'oscillateur est proportionnel à la différence entre la fréquence du signal à l'entrée de l'oscillateur et la fréquence propre fos de ce dernier. En conséquence, on peut penser à ajuster la valeur de la fréquence propre de l'oscillateur en fonction de la fréquence d'horloge bits fsr du signal reçu lors de la conception du circuit. Mais cette solution reste imparfaite dans la mesure où la valeur de cette fréquence d'horloge bits fsr n'est justement pas connue avec précision (ce qui constitue le problème technique initial principal nécessitant la présence d'un circuit d'extraction d'horloge dans le récepteur). En outre, elle nécessiterait en tout état de cause un réglage du circuit pour chaque application. Si un tel réglage est admissible dans le contexte d'un prototype de laboratoire, il n'est pas acceptable dans la plupart des applications industrielles d'un tel circuit.

FR 2838265 a proposé de résoudre ce problème de décalage de phase en prévoyant une logique de décision pour sélectionner une valeur parmi différentes valeurs fournies par une pluralité de bascules d'échantillonnage décalées selon des durées de décalage distinctes par rapport aux impulsions du signal d'horloge de réception. Il s'avère qu'en pratique cette solution n'est pas réellement efficace dans toutes les situations.

Également, US 6924705 décrit un circuit PLL comprenant un détecteur de phase numérique, une pompe de charge et un filtre de boucle contrôlant un oscillateur contrôlé en tension, ce dernier recevant le signal de données en entrée via un doubleur de fréquence. Outre que la réalisation pratique du détecteur de phase numérique n'est pas indiquée, ce circuit présente l'inconvénient de ne pas pouvoir être réalisé entièrement sous forme numérique, puisque la pompe de charge et le filtre de boucle sont des composants de type analogique. En conséquence, la réalisation d'un circuit conforme à ce document est étroitement dépendante en pratique de la technologie semi-conducteur mise en oeuvre et ne peut pas être simplement et rapidement adaptée à une autre technologie semi-conducteur, sans nécessiter au préalable une nouvelle conception du circuit. En outre, ce circuit présentant une faible plage de fréquences admissibles en entrée et n'étant pas automatiquement adapté au signal reçu, nécessite des réglages manuels externes de la fréquence libre de l'oscillateur et de la différence de délais de propagation entre les différentes lignes, en particulier celle permettant d'extraire les données et celle permettant d'extraire l'horloge. Dès lors, le circuit décrit dans ce document ne peut pas faire l'objet d'une exploitation à l'échelle industrielle dans les applications où la période de développement doit être minimisée et/ou dans celles où il est nécessaire de pouvoir migrer fréquemment d'une technologie semi-conducteur à une autre et/ou dans celles où la fréquence du signal reçu peut varier dans une large plage de valeurs.

US 5671259 décrit un circuit d'extraction d'horloge comprenant un circuit résonnant implémenté avec des composants discrets montés sur circuit imprimé et une boucle numérique d'asservissement en phase comprenant un circuit de comptage permettant de mettre en forme un signal de commande d'ajustage de la fréquence du circuit résonnant. Le fonctionnement d'un tel circuit résonnant n'est pas compatible avec une réalisation en circuit(s) intégré(s) (le facteur de qualité des composants dans cette technologie étant très insuffisant) et ne permet d'atteindre que des fréquences de fonctionnement peu élevées (de l'ordre de 2 MHz pour le rythme de données entrantes). En outre, avec un tel circuit résonnant, en l'absence de transition dans le signal de données, l'oscillation disparaît au bout de quelques cycles, de sorte que ce type de circuit n'est pas compatible avec des signaux de données présentant peu ou pas de transitions sur certaines périodes. Par ailleurs, dans ce document, la phase du signal d'entrée peut varier sur plus ou moins un quart de bit, soit une variation absolue d'un demi bit sans que la boucle d'asservissement en phase ne réagisse, de sorte que les décalages de phase accidentels entre 0 % et 50 % ne sont pas détectés. En outre, le circuit de comptage est un compteur sur 20 bits, seuls les 8 bits les plus significatifs étant utilisés pour la commande du circuit résonant. Un tel filtrage extrêmement élevé (une différence de 4096 décalages de phase successifs étant nécessaire avant d'entraîner un ajustement) est en pratique totalement inefficace. Surtout, il ne permet en aucune manière, contrairement à ce qu'indique ce document, de résoudre les éventuels décalages de phase accidentels présents dans le signal d'entrée.

Ainsi, malgré d'intensives recherches effectuées depuis longtemps sur ces circuits d'extraction d'horloge, le besoin persiste de pouvoir proposer une solution simple, compatible avec une exploitation en grande série à l'échelle industrielle dans la plupart des applications pratiques actuelles de ces circuits, y compris avec des liaisons à très haut débit -notamment supérieur à 500 Mbits/s- et/ou à très haute fréquence -notamment supérieure à 500 MHz -, dont la consommation énergétique est acceptable, et qui ne nécessite ni réglages externes ni conception spécifique, chaque circuit fabriqué étant nécessairement réglé du fait de sa conception indépendamment de la technologie de réalisation mise en oeuvre, et qui reste parfaitement en phase avec les signaux de données d'entrée tout en étant compatible avec une très grande variété de tels signaux de données d'entrée, y compris lorsque ces derniers présentent des périodes présentant peu de transitions ou sans transitions, ou de nombreux décalages de phase accidentels.

L'invention vise donc à proposer une telle solution. Les inventeurs ont en effet constaté qu'il était possible, moyennant une architecture spécifique, de proposer pour la première fois un dispositif d'extraction d'horloge, et plus particulièrement un dispositif d'extraction d'horloge et de données, qui présente ces qualités, et en particulier qui soit très simple de réalisation, « auto réglé » (c'est-à-dire ne nécessitant aucun réglage manuel externe) en présentant une large plage d'accrochage et un taux d'erreurs de bits très faible tout en étant compatible avec une très grande variété de signaux de données en entrée.

L'invention vise également à proposer un tel dispositif qui soit peu sensible à la variation de qualité des signaux reçus, et en particulier qui soit compatible avec des signaux pouvant présenter une densité de transitions variable, et du bruit.

L'invention vise également à proposer un tel dispositif qui puisse être réalisé quasiment entièrement sous forme de composants numériques, et notamment dont la boucle d'asservissement en phase est intégralement réalisée sous forme de composants numériques. En effet, les inventeurs ont déterminé qu'il en résulte d'une part une plage plus étendue de fréquences admissibles pour le signal reçu, d'autre part une simplicité de réalisation du dispositif, et en particulier une possibilité de migration d'une technologie semi-conducteur à une autre de façon simple et rapide. La conception de chaque circuit peut être effectuée à partir de bibliothèques de fonctions standards sans nécessiter la mise au point de composants spécifiques, contrairement aux dispositifs antérieurs (par exemple les portes contrôlées en tension dans un circuit DLL ou les composants analogiques d'un circuit PLL).

Dans tout le texte, on désigne par « composant numérique » tout composant électronique présentant au moins une borne d'entrée et/ou sortie, chaque borne véhiculant un signal dont l'état peut varier parmi une pluralité discrète d'états, notamment 1 et 0, sans que la valeur analogique réelle du signal correspondant n'influe sur le fonctionnement du composant ou du circuit dans lequel il est intégré. Par ailleurs, dans tout le texte, les termes « entrée » et « sortie » d'un composant désignent une borne de connexion ou un ensemble de bornes de connexion recevant ou, respectivement, délivrant un signal unique. Le signal appliqué sur une entrée ou délivré par une sortie peut donc être, sauf précision complémentaire, aussi bien un signal série qu'un signal parallèle et peut être constitué d'une seule voie ou de plusieurs voies (notamment dans le cas d'une architecture de type différentiel).

L'invention concerne donc un dispositif d'extraction d'horloge à partir d'un signal série en bande de base, dit signal reçu, représentatif de données numériques et codé avec un signal d'horloge présentant une fréquence d'horloge bits fsr, comprenant :
- un circuit recevant un signal issu du signal reçu et cadencé à la fréquence d'horloge bits fsr, et délivrant, sur au moins une sortie d'horloge, un signal d'horloge, dit signal d'horloge de réception, au moins sensiblement synchronisé et en phase avec la fréquence d'horloge bits fsr du signal reçu,
- une boucle d'asservissement en phase comprenant :
   - une première entrée reliée à une sortie d'horloge du circuit délivrant un signal d'horloge de réception,
   - une deuxième entrée alimentée par un signal issu du signal reçu,
   - un détecteur numérique de phase comprenant un détecteur avance-retard relié aux première et deuxième entrées et délivrant sur au moins une sortie un signal numérique, dit signal d'états de phase, représentatif d'un décalage de phase entre le signal d'horloge de réception et le signal reçu, et du sens de ce décalage,
   - une sortie délivrant un signal, dit signal de commande, reliée à une entrée, dite entrée de commande, du circuit délivrant un signal d'horloge de réception, adaptée pour que la valeur de la fréquence du signal d'horloge de réception dépende de la valeur du signal de commande reçu sur cette entrée de commande,
   - un circuit, dit circuit de comptage, présentant une entrée reliée à ladite sortie du détecteur numérique de phase, ledit circuit de comptage étant adapté pour réaliser au moins un filtrage par comptage/décomptage numérique sur les variations des valeurs relatives du signal numérique délivrées dans le temps par le détecteur de phase, et pour délivrer un signal de commande sous forme numérique dont la valeur est fonction du résultat de ce(s) filtrage(s), cette valeur du signal de commande étant adaptée pour imposer une valeur de la fréquence du signal d'horloge de réception égale à une valeur ainsi filtrée de la fréquence d'horloge bits fsr du signal d'horloge de réception
caractérisé en ce que :
- le circuit délivrant un signal d'horloge de réception est un oscillateur verrouillé en injection à commande numérique, comprenant une entrée numérique de commande adaptée pour pouvoir recevoir le signal de commande délivré par la boucle d'asservissement en phase sous forme numérique, et pour que la valeur de la fréquence propre fos de l'oscillateur dépende de la valeur du signal de commande reçu sur cette entrée de commande,
- la boucle d'asservissement en phase comprend un circuit présentant au moins une entrée reliée respectivement à la(aux) sortie(s) du détecteur avance-retard, et délivrant sur au moins une sortie, un signal numérique, dit signal d'états de phase filtré :
- ayant une première valeur relative après réception d'un nombre prédéterminé N supérieur à 1 de valeurs identiques successives en entrée, correspondant à N bits de données successifs du signal reçu pour lesquels le détecteur avance-retard a détecté un décalage de phase dans le même sens,
- ayant une deuxième valeur relative après réception de N valeurs identiques successives en entrée, correspondant à N bits de données successifs du signal reçu pour lesquels le détecteur avance-retard a détecté un décalage de phase dans l'autre sens,
- ayant une troisième valeur relative dans les autres cas,
de sorte que la valeur relative du signal d'états de phase filtré est représentative de la présence d'un décalage de phase dans le même sens, et du sens de ce décalage de phase, pour N bits de données successifs du signal reçu, entre les fronts du signal d'horloge de réception et les bits de données correspondants du signal reçu.

L'invention s'étend également à un dispositif d'extraction d'horloge et de données numériques comprenant un dispositif d'extraction d'horloge selon l'invention. Un dispositif d'extraction d'horloge et de données numériques selon l'invention comprend en outre un circuit d'échantillonnage du signal reçu avec le signal d'horloge de réception, ce circuit d'échantillonnage ayant une première entrée, dite entrée de signal, reliée à l'entrée de réception, et une deuxième entrée, dite entrée d'horloge, reliée à une sortie d'horloge'de l'oscillateur verrouillé en injection, ce circuit d'échantillonnage étant adapté pour délivrer sur au moins une sortie de données, des données numériques transmises par le signal reçu, et est caractérisé en ce qu'il comprend au moins un circuit déphaseur adapté pour introduire une différence de phase constante entre l'entrée de signal et l'entrée d'horloge du circuit d'échantillonnage, la différence de phase totale entre ces deux entrées résultant de chaque circuit déphaseur étant adaptée pour garantir un alignement en phase du signal à l'entrée de signal et du signal à l'entrée d'horloge.

Avantageusement et selon l'invention, le détecteur avance-retard est adapté pour délivrer sur une première sortie un signal numérique représentatif de la présence d'une avance de phase entre le signal horloge de réception et le signal reçu, et sur une deuxième sortie un signal numérique représentatif de la présence d'un retard de phase entre le signal d'horloge de réception et le signal reçu.

Avantageusement et selon l'invention, le détecteur avance-retard est adapté pour échantillonner le signal reçu sur les fronts montants et descendants du signal d'horloge de réception. Plus particulièrement, avantageusement et selon l'invention, le détecteur avance-retard est adapté pour réaliser un double échantillonnage, l'un en phase avec les fronts du signal d'horloge de réception, l'autre en quadrature avec les fronts du signal horloge de réception de façon à déterminer l'état intermédiaire du signal reçu.

Par ailleurs, avantageusement et selon l'invention, un dispositif selon l'invention est caractérisé en ce que ledit circuit délivrant le signal d'états de phase filtré est un convertisseur décisionnel.

Dans un mode de réalisation de l'invention, N=2. Toute autre valeur peut néanmoins être choisie, selon le niveau de filtrage souhaité. En effet, un tel convertisseur décisionnel a pour effet de réaliser un premier type de filtrage à partir de valeurs relatives des décalages de phase détectés par le détecteur de phase numérique. Ce premier filtrage permet d'assimiler à du bruit des décalages de phase accidentels, puisque seule une série de N états identiques du décalage de phase aura un effet sur la sortie du convertisseur décisionnel. Typiquement, ce premier filtrage permet d'éviter de prendre en compte les phénomènes de dérives de phase accidentelles non permanentes telles que les phénomènes de «jitter». En particulier, il est à noter que les séries de bits de données présentant un décalage de phase dans le même sens comprenant un nombre de bits de données pouvant aller jusqu'à N-1 ne modifient pas la valeur du signal d'états de phase filtré.

Par ailleurs, avantageusement et selon l'invention, ledit circuit de comptage comprend au moins un circuit, dit circuit accumulateur, comprenant au moins une entrée recevant un signal numérique issu de chaque signal d'états de phase délivré par le détecteur avance-retard, ce circuit accumulateur étant adapté pour délivrer un signal numérique, dit signal de comptage/décomptage, dont la valeur relative est représentative de la réception d'un cumul de valeurs relatives présentées sur l'(les)entrée(s) de ce circuit accumulateur.

Avantageusement et selon invention, ledit circuit de comptage comprend successivement un convertisseur décisionnel et un circuit accumulateur adapté pour cumuler les valeurs relatives du signal d'états de phase filtré délivrée par le convertisseur décisionnel.

Dans un dispositif selon l'invention, en combinaison avec le premier type de filtrage décrit ci-dessus, ou en variante, un autre type de filtrage peut être réalisé par ledit circuit de comptage. Ainsi, avantageusement et selon l'invention, le circuit accumulateur présente une sortie parallèle, et est adapté pour délivrer sur cette sortie parallèle un signal numérique parallèle de comptage/décomptage, et l'oscillateur verrouillé en injection comprend une entrée numérique parallèle de commande comprenant un nombre de bits inférieur à celui de la sortie numérique parallèle du circuit accumulateur, seule une partie des bits de poids forts de la sortie numérique parallèle du circuit accumulateur étant reliés aux bits de l'entrée numérique parallèle de commande de l'oscillateur verrouillé en injection, de sorte que le dit signal de commande délivré par le circuit de comptage est formé de ladite partie des bits de poids fort dudit signal de comptage/décomptage.

Ainsi, la valeur du signal de commande n'est modifiée qu'à partir du moment où le circuit accumulateur a compté/décompté un nombre seuil prédéterminé M de bits de données ayant un décalage de phase dans le même sens entre les fronts du signal d'horloge de réception et les bits de données correspondants du signal reçu.

Dans un mode de réalisation selon l'invention, la sortie numérique parallèle du circuit accumulateur comprend par exemple 8 ou 9 bits, et l'entrée numérique parallèle de l'oscillateur verrouillé en injection comprend 5 bits, seuls les 5 bits de poids forts de la sortie numérique parallèle du circuit accumulateur étant reliés aux 5 bits de l'entrée numérique parallèle de commande de l'oscillateur verrouillé en injection. Ainsi, le signal de commande n'est modifié qu'à partir du moment où le circuit accumulateur a détecté un déséquilibre du cumul (représentatif de décalages de phase dans le même sens) au moins égal à 111 (valeur binaire) sur les valeurs relatives qu'il reçoit en entrée. Dans cet exemple, en l'absence de convertisseur décisionnel, on aurait donc M=111.

Ledit circuit accumulateur peut être réalisé par un ou plusieurs additionneur(s) et/ou par un ou plusieurs compteur(s). Il est à noter que du fait de la fonction de comptage et décomptage, les M bits de données d'une série de bits de données de mêmes décalages de phase déclenchant une modification de la sortie de commande ne sont pas nécessairement tous successifs. Par exemple, ils peuvent être au contraire séparés par des bits de données pour lesquels aucun décalage de phase n'est détecté, voire par des bits de données présentant un décalage de phase en sens contraire, ultérieurement compensés par d'autres bits de données subséquents. Ce deuxième type de filtrage détecte donc une dérive générale de la phase sur au moins M bits de données.

Le fait de ne retenir qu'une partie des bits (de poids fort) de la sortie numérique parallèle du circuit accumulateur pour faire office de signal de commande de l'oscillateur verrouillé en injection permet de réaliser ainsi un deuxième type de filtrage ayant des caractéristiques quelque peu différentes du premier type de filtrage. Quoi qu'il en soit, le filtrage réalisé sur les variations des décalages de phase est adapté en fonction de la réponse dynamique souhaitée pour la boucle d'asservissement.

Dans les variantes de réalisation du dispositif selon l'invention dans lesquelles les deux types de filtrage sont utilisés successivement en combinaison, le fait de pouvoir réaliser ce filtrage en deux étages successifs dont l'un est formé du convertisseur décisionnel, et l'autre dudit circuit accumulateur, permet en particulier de réduire la fréquence de travail de l'accumulateur, ce qui facilite sa mise en oeuvre à haute fréquence. En outre, le premier type de filtrage permet de minimiser le risque d'une variation du signal de commande à haute fréquence lorsque les données présentent une dérive de phase accidentelle («jitter») alors que le dit circuit accumulateur a précédemment décompté un nombre de bits de données successifs de mêmes décalages de phase proche de la valeur seuil qui déclenche la variation du signal de commande. Pour éviter ce phénomène de variations à haute fréquence il est également possible de réaliser le circuit accumulateur à l'aide de plusieurs additionneurs et/ou plusieurs compteurs en cascade avec un dispositif de rechargement d'une valeur intermédiaire, par exemple une valeur médiane, lorsque ladite valeur seuil a été dépassée, de sorte que le circuit accumulateur reprend le comptage/décomptage à partir de cette valeur intermédiaire.

Ce(s) filtrage(s) numérique(s) résultant de la structure du convertisseur décisionnel et/ou de la liaison entre le circuit accumulateur et l'entrée numérique de commandes de l'oscillateur verrouillé en injection permet(tent) de s'affranchir de tout composant spécifique de filtrage dans la boucle d'asservissement en phase.

Dans un mode de réalisation avantageux et selon l'invention, l'entrée numérique de commande de l'oscillateur verrouillé en injection est reliée à un circuit comprenant une pluralité de commutateurs, chaque commutateur étant relié en série avec au moins un condensateur intégré dans le circuit de l'oscillateur de façon à modifier sa fréquence propre. Avantageusement et selon l'invention, chaque bit de l'entrée numérique de commande est relié à l'un des commutateurs.

En outre, avantageusement et selon l'invention, le circuit d'extraction d'horloge comprend en outre un circuit, dit générateur d'impulsions de synchronisation, générant un signal d'impulsions de courant à la fréquence de fronts du signal reçu, et adapté au fonctionnement de l'oscillateur verrouillé en injection, ce générateur d'impulsions de synchronisation étant adapté pour délivrer le signal d'impulsions de courant sur une sortie unique reliée uniquement à une entrée en courant de l'oscillateur verrouillé en injection. Les impulsions en courant délivrées par ce générateur d'impulsions de synchronisation sont adaptées à l'entrée de l'oscillateur verrouillé en injection de façon à assurer son fonctionnement, c'est-à-dire le verrouillage de l'oscillateur sur la fréquence d'horloge bits fsr.

Par ailleurs, tout type d'oscillateur verrouillé en injection peut être utilisé dans le cadre de l'invention. Il peut s'agir en particulier d'un oscillateur à relaxation de type RC ou à source de courant, d'un oscillateur astable à portes logiques ou émetteurs couplés, d'un oscillateur en anneau, d'un oscillateur quasi-sinusoïdal à pont de Wien, déphasage ou LC, d'un oscillateur Colpitts, Hartley, Clapp, Pierce ou à résistance négative à circuit résonant LC, à lignes de transmission ou résonateur de type quartz, résonateur à ondes de surface, à MEMS ou piézo-électrique intégré,...Néanmoins, avantageusement et selon l'invention, l'oscillateur verrouillé en injection est du type formé d'un circuit résonnant LC. Un tel oscillateur présente en particulier l'avantage de minimiser la dérive de phase (« jitter ») intrinsèque. Plus particulièrement, avantageusement et selon l'invention l'oscillateur verrouillé en injection comprend deux branches comprenant chacune un transistor à effet de champ à résistance négative, les deux transistors étant couplés selon une topologie différentielle. Il peut s'agir d'un oscillateur tel que décrit dans FR 2838265.

L'invention permet ainsi d'apporter des avantages décisifs dans la conception des dispositifs d'extraction d'horloge, et plus particulièrement des dispositifs d'extraction d'horloge et de données numériques, en permettant une exploitation à l'échelle industrielle d'un circuit dont le fonctionnement est basé sur un oscillateur verrouillé en injection.

En particulier, un dispositif selon l'invention est exempt de pompe de charge et de filtre de boucle, et plus généralement de composant analogique dans la boucle d'asservissement en phase. Dès lors, dans un dispositif selon l'invention la boucle d'asservissement de phase peut être développée avec une conception homogène, entièrement numérique, simple et rapide.

Un dispositif selon l'invention est aussi complètement autonome, c'est-à-dire ne nécessite aucun réglage externe manuel ou autre, ni aucune calibration. Ainsi, avantageusement, un dispositif selon l'invention est exempt de tout moyen de réglage manuel externe. De surcroît, cette autonomie est obtenue avec une grande simplicité de réalisation.

Un dispositif selon l'invention ne nécessite pas non plus la présence d'une référence de fréquence externe, et ce contrairement à une PLL traditionnelle. En outre, quelques bits de données suffisent pour assurer la synchronisation au démarrage. Du fait de sa très grande simplicité, l'architecture d'un dispositif selon l'invention permet sa réalisation avec un très faible nombre de composants élémentaires à faible consommation d'énergie (donc une surface totale réduite et une consommation totale plus faible). Un dispositif selon l'invention peut également être conçu en technologie numérique, notamment en ce qui concerne la boucle d'asservissement en phase, sans nécessiter l'intervention d'un concepteur possédant un grand savoir-faire (contrairement aux dispositifs antérieurs à base de PLL dans lesquels il est en particulier très difficile de réaliser un comparateur phase/fréquence fonctionnant à haute fréquence). Il est aussi possible, avec un dispositif conforme à l'invention de conception simple, d'atteindre des vitesses de transmission proches des limites offertes par la technologie semi-conducteur. Il est en cas particulier possible d'atteindre des vitesses de transmission sensiblement plus élevées qu'avec des circuits antérieurs à base de PLL ou de DLL. En outre, il est possible de réaliser un dispositif selon l'invention avec une technologie semi-conducteur quelconque (CMOS, bipolaire, SiGe,...).

Contrairement à un circuit à base de DLL, un dispositif selon l'invention est peu sensible aux bruits sur le signal reçu, et le codage des données présente un taux d'expansion similaire à celui d'une PLL traditionnelle, c'est-à-dire bien inférieur à celui requit pour une DLL.

Par ailleurs, compte tenu de la simplicité et de l'efficacité de la boucle d'asservissement en phase, dans un dispositif selon l'invention, la fréquence propre fos de l'oscillateur est toujours égale à la fréquence d'horloge bits fsr du signal d'horloge de réception, par conséquent l'écart de phase entre le signal d'horloge délivré par l'oscillateur et le signal reçu est fixe. Or, l'ensemble des autres éléments constitutifs du dispositif pouvant entraîner un déphasage constant entre les deux entrées du circuit d'échantillonnage, il est possible de déterminer le retard différentiel de phase structurel constant entre ces deux entrées du circuit d'échantillonnage. Dès lors, il suffit de prévoir un (ou plusieurs) circuit(s) déphaseur(s) pour garantir un alignement en phase entre les deux entrées du circuit d'échantillonnage, sans nécessiter aucun réglage extérieur, pour que le dispositif selon l'invention puisse fonctionner de façon autonome et stable avec une large plage de capture. En outre, dans un dispositif selon l'invention, le circuit d'échantillonnage peut-être simplement constitué d'une simple bascule D.

Il est à noter à cet égard que ce (ces) circuit(s) déphaseur(s) est (sont) prévu(s) en supplément à l'éventuel circuit déphaseur parfois nécessairement prévu à l'entrée d'un circuit tel qu'un comparateur de phase, pour compenser les déphasages introduits par certaines architectures de ce type de circuit. Un tel circuit déphaseur nécessaire au fonctionnement d'un comparateur de phase qu'il alimente, est fonctionnellement différent du (des) circuit(s) déphaseur(s) d'un dispositif selon l'invention, dont la fonction est d'introduire un déphasage supplémentaire pour compenser le déphasage total entre les deux entrées du circuit d'échantillonnage.

Avantageusement un dispositif selon l'invention est réalisé sous forme d'au moins un circuit intégré incorporant au moins l'oscillateur verrouillé en injection. Un dispositif d'extraction d'horloge et de données numériques selon l'invention est adapté pour pouvoir fonctionner avec une fréquence d'horloge bits fsr supérieure à 500 MHz.

Ainsi, l'invention permet d'obtenir, pour la première fois, un circuit d'extraction d'horloge, et plus particulièrement un circuit d'extraction d'horloge et de données numériques, parfaitement autonome et stable, pouvant faire l'objet d'une exploitation à l'échelle industrielle dans de nombreuses applications.

L'invention concerne également un dispositif d'extraction d'horloge, et plus particulièrement un dispositif d'extraction d'horloge et de données numériques, caractérisé en combinaison par tout ou partie des caractéristiques mentionnées ci-dessus ou ci-après.

D'autres buts, caractéristiques et avantages de l'invention apparaîtront à la lecture de la description suivante donnée à titre non limitatif et qui se réfère aux figures annexées dans lesquelles :
- la figure 1 est un schéma synoptique fonctionnel général illustrant un dispositif d'extraction d'horloge et de données numériques conforme à un premier mode de réalisation de l'invention,
- la figure 2 est un schéma synoptique fonctionnel d'un mode de réalisation du détecteur avance-retard du dispositif de la figure 1,
- la figure 3 est un schéma synoptique fonctionnel d'un mode de réalisation du convertisseur décisionnel du dispositif de la figure 1,
- la figure 4 est un schéma illustrant un mode de réalisation d'un oscillateur verrouillé en injection pouvant être utilisé dans un dispositif conforme à l'invention,
- la figure 5 est un schéma illustrant un exemple de réalisation d'un additionneur 8 bits pouvant être utilisé dans le dispositif de la figure 1,
- la figure 6 est un schéma illustrant un exemple de réalisation d'un accumulateur 2 bits pouvant être utilisé pour réaliser l'additionneur de la figure 5,
- la figure 7 est un schéma illustrant un mode de réalisation d'un bloc de capacités à l'entrée numérique de commande de l'oscillateur de la figure 4,
- la figure 8 est un schéma illustrant un deuxième mode de réalisation d'un circuit de comptage d'un dispositif conforme à l'invention,
- la figure 9 est un schéma illustrant un troisième mode de réalisation d'un circuit de comptage d'un dispositif conforme à l'invention,
- la figure 10 est un schéma illustrant un quatrième mode de réalisation d'un circuit de comptage d'un dispositif conforme à l'invention.

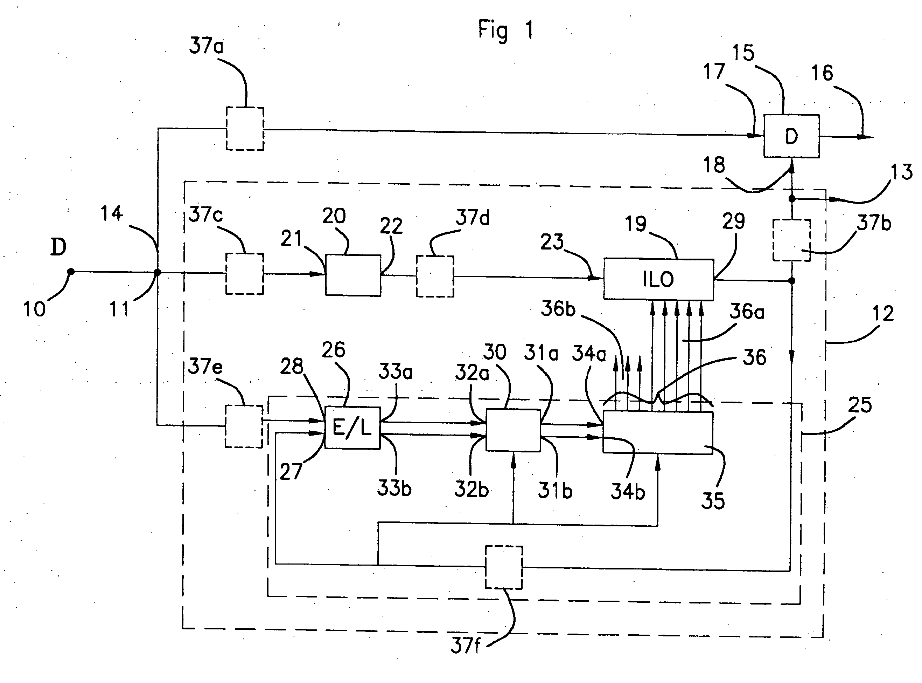

Un dispositif d'extraction d'horloge et de données numériques conforme à l'invention représenté sur la figure 1 reçoit sur une entrée principale, dite entrée de réception 10, un signal, dit signal reçu, qui est un signal série en bande de base représentatif de données numériques D et est codé avec un signal d'horloge présentant une fréquence d'horloge bits fsr. En général ce signal reçu est un signal codé du type NRZ (« non return to zero ») reçu sur un canal de transmission d'une liaison série en bande de base. Ce canal de transmission peut être formé d'un fil conducteur électrique unique, ou d'une fibre optique unique, ou d'une liaison radio fréquence monocanal (signal non différentiel). L'invention est néanmoins applicable également dans le cas d'un signal reçu du type transmis en différentiel, le canal de transmission comprenant alors deux lignes transmettant deux composantes en opposition de phase. L'invention est aussi applicable à d'autres types de codage du signal reçu, par exemple NRZI (« non retum to zero inverted»).

L'entrée de réception 10 est reliée à un noeud de dérivation 11 auquel sont reliées deux branches en parallèle, à savoir une première branche d'extraction d'horloge 12 conforme à l'invention et générant sur une sortie d'horloge 13 un signal d'horloge, dit signal d'horloge de réception H, synchronisé et en phase avec la fréquence d'horloge bits fsr du signal reçu, et, une autre deuxième branche 14 comprenant un circuit d'échantillonnage 15 du signal reçu avec le signal d'horloge de réception H, ce circuit d'échantillonnage 15 étant apte à délivrer, sur une sortie de données 16, des données numériques transmises par le signal reçu.

Le circuit d'extraction d'horloge 12 comprend un oscillateur verrouillé en injection 19 alimenté par un générateur d'impulsions de synchronisation 20, ce dernier présentant une entrée 21 reliée au noeud 11 de l'entrée de réception 10. Le générateur d'impulsions de synchronisation 20 présente une sortie unique 22 (qui peut être formée par deux lignes dans le cas d'une topologie différentielle) reliée uniquement à l'entrée en courant 23 de l'oscillateur verrouillé en injection 19. Le signal d'impulsions de courant fourni par le générateur d'impulsions de synchronisation 20 est adapté au fonctionnement de l'oscillateur verrouillé en injection 19 et est cadencé à la fréquence de fronts des données D du signal reçu. L'ensemble peut être réalisé par exemple comme décrit par FR 2838265. En particulier, l'oscillateur verrouillé en injection 19 est alors du type formé d'un circuit résonnant LC symétrique définissant la fréquence d'oscillations libres fos d'oscillation, et doté de deux branches croisées comprenant chacune un transistor à effet de champ à résistance négative, les deux transistors étant ainsi couplés selon une topologie différentielle. L'oscillateur verrouillé en injection 19 présente une sortie d'horloge 29 délivrant un signal d'horloge synchronisé et en phase avec la fréquence d'horloge bits du signal reçu.

Le circuit d'échantillonnage 15 comprend une première entrée, dite entrée de signal 17, reliée par la deuxième branche 14 à l'entrée de réception 10, et une deuxième entrée, dite entrée d'horloge 18, reliée à la sortie d'horloge du circuit d'extraction d'horloge 12, c'est-à-dire à la sortie d'horloge 29 de l'oscillateur 19. Ce circuit d'échantillonnage 15 peut être formé d'une simple bascule D.

L'oscillateur verrouillé en injection 19 comprend par ailleurs une entrée, dite entrée de commande adaptée pour que la valeur de la fréquence propre fos de l'oscillateur dépende de la valeur du signal numérique de commande reçu sur cette entrée de commande. L'entrée de commande est une entrée parallèle numérique qui, dans l'exemple représenté, comprend 5 bits 24a, 24b, 24c, 24d, 24e.

L'oscillateur 19 peut être réalisé à partir de tout type d'oscillateur dès lors qu'il peut être adapté pour présenter une entrée de commande numérique comme décrit ci-après. Il peut s'agir en particulier d'un oscillateur à relaxation de type RC ou à source de courant, d'un oscillateur astable à portes logiques ou émetteurs couplés, d'un oscillateur en anneau, d'un oscillateur quasi-sinusoïdal à pont de Wien, déphasage ou LC, d'un oscillateur Colpitts, Hartley, Clapp, Pierce ou à résistance négative à circuit résonant LC, à lignes de transmission ou résonateur de type quartz, résonateur à ondes de surface, à MEMS ou piézo-électrique intégré,...

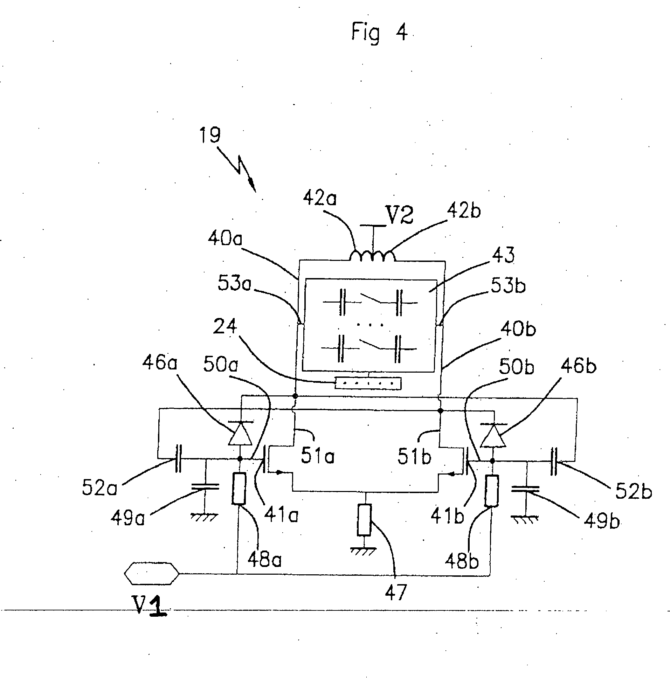

L'oscillateur 19 est par exemple réalisé comme décrit par FR 2838265 et représenté schématiquement sur figure 4. Il est alors du type formé d'un circuit résonnant LC symétrique définissant la fréquence d'oscillations libres fos, et doté de deux branches croisées 40a, 40b comprenant chacune un transistor à effet de champ 41a, respectivement 41b à résistance négative, les deux transistors 41a, 41b étant ainsi couplés selon une topologie différentielle. La paire de transistors 41a, 41b est chargée par un circuit LC symétrique définissant la fréquence d'oscillation à partir d'une tension de référence de polarisation V2 appliquée entre deux inductances 42a, respectivement 42b, et d'une source de courant 47 dont la sortie est au potentiel le plus faible et qui peut être simplement formée d'une résistance série reliée à un noeud de jonction des deux sources des transistors 41a, 41b.

Chaque transistor 41a, 41b est par ailleurs polarisé par une tension de polarisation V1 appropriée appliquée sur son drain 50a, 50b par l'intermédiaire d'une résistance série 48a, 48b et d'une capacité parallèle 49a, 49b.

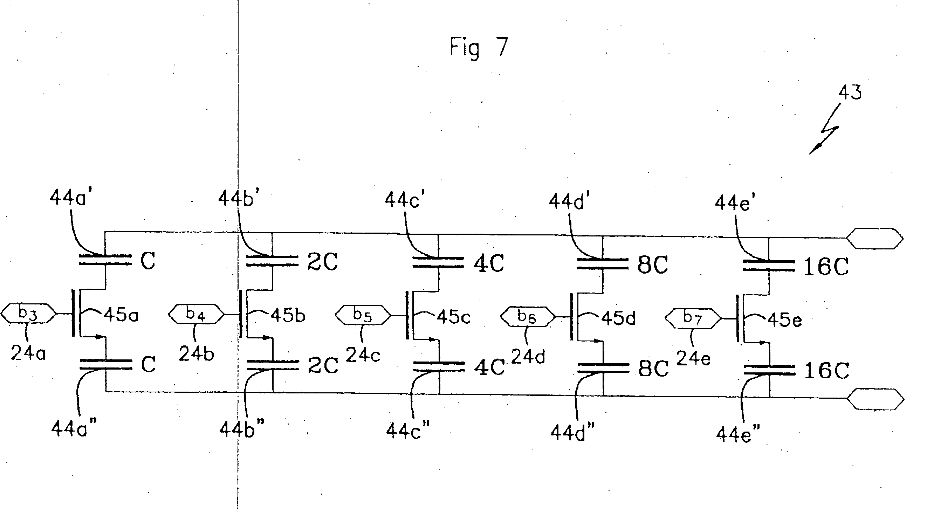

Les capacités parallèles du circuit résonnant LC sont formées d'un bloc 43 de capacités associées chacune respectivement à un commutateur 45a, 45b, 45c, 45d, 45e, chaque commutateur recevant l'un des bits 24a, 24b, 24c, 24d, 24e de l'entrée numérique parallèle de commande de l'oscillateur 19. Les capacités parallèles sont associées de telle sorte que la variation d'un incrément (une unité) du signal numérique reçu à l'entrée entraîne une variation d'une même valeur Δf de la fréquence d'oscillation fos de l'oscillateur 19. Dans le mode de réalisation de la figure 7, chaque commutateur 45a, 45b, 45c, 45d, 45e, est interposé entre deux condensateurs 44a', 44b', 44c', 44d', 44e', et respectivement 44a", 44b", 44c", 44d", 44e", de même valeur disposés symétriquement en série par rapport à ce commutateur, ces deux condensateurs formant la dite capacité associée au commutateur. Chaque commutateur 45a, 45b, 45c, 45d, 45e, est formé d'un transistor à effet de champ, et les valeurs des capacités sont égales à 2ⁿ x 2C, n étant le rang (0, 1, 2, 3, 4) du bit b3, b4, b5, b6, b7 considéré du signal numérique de commande appliqué sur l'entrée numérique 24a, 24b, 24c, 24d, 24e, C étant une valeur prédéterminée de capacité, et la valeur de capacité de chaque condensateur 44a', 44a", 44b', 44b", 44c', 44c", 44d', 44d", 44e', 44e", étant respectivement égale à C, C, 2C, 2C, 4C, 4C, 8C, 8C, 16C, 16C comme représenté figure 7.

La valeur du pas de variation Δf est choisie suffisamment faible, de préférence inférieure à 1 % de la valeur moyenne de la fréquence d'oscillation fos, notamment de l'ordre de 0,3 % de cette valeur moyenne. Par exemple, Δf est de l'ordre de 30 MHz pour une fréquence d'oscillation fos de l'ordre de 10 GHz.

L'amplitude d'oscillation de l'oscillateur 19 est contrôlée grâce à deux diodes 46a, respectivement 46b montées entre le drain 50a, 50b et la grille 51a, 51b de chaque transistor 41a, 41b correspondant par l'intermédiaire d'une capacité de filtrage 52a, 52b.

Le circuit d'extraction d'horloge 12 du dispositif selon l'invention comprend une boucle d'asservissement en phase 25 entièrement formée de composants numériques. Cette boucle d'asservissement en phase 25 comprend un détecteur avance-retard 26 présentant deux entrées 27, 28. La première entrée 27 du détecteur avance-retard 26 est reliée à la sortie 29 de l'oscillateur 19 de façon à recevoir le signal d'horloge de réception H généré par l'oscillateur sur cette sortie 29. La deuxième entrée 28 est reliée au noeud de dérivation 11 et donc à l'entrée de réception 10. Ainsi, le signal reçu est délivré à la deuxième entrée 28 du détecteur avance-retard 26.

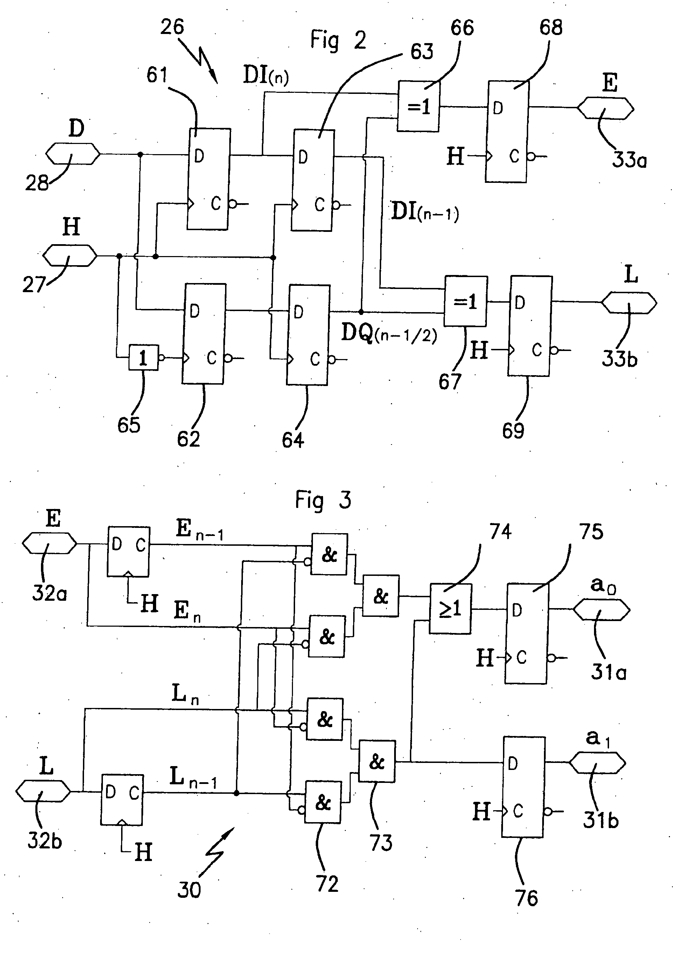

Un mode de réalisation du détecteur avance-retard 26 est représenté sur figure 2. Ce détecteur avance retard 26 présente deux sorties numériques parallèles 33a, 33b sur chacune desquelles il délivre un signal, dit signal d'états de phase E, respectivement L, représentatif de l'existence et du sens d'un décalage de phase entre ses deux entrées 27, 28, c'est-à-dire entre les données D du signal reçu et le signal d'horloge de réception H fourni par l'oscillateur 19. En particulier les signaux E et L délivrés respectivement sur les sorties numériques parallèles 33a, 33b du détecteur avance-retard 26 sont nuls lorsque les signaux sur ses deux entrées 27, 28 sont en phase. La première sortie 33a du détecteur avance-retard 26 est un signal numérique E sur 1 bit qui identifie la présence d'une avance de phase entre les deux entrées 27, 28. Dans l'exemple décrit, ce signal E est égal à 1 lorsqu'une avance de phase est détectée, et est égal à 0 lorsque les deux entrées 27, 28 sont en phase. La deuxième sortie 33b du détecteur avance-retard 26 délivre un signal numérique L sur 1 bit qui identifie la présence d'un retard de phase entre les deux entrées 27, 28. Dans l'exemple décrit, ce signal L est égal à 1 lorsqu'un retard de phase est détecté, et est égal à 0 lorsque les deux entrées 27, 28 sont en phase.

Tout type de détecteur avance-retard 26 numérique peut être utilisé dans un dispositif selon l'invention. Il peut s'agir en particulier d'une cellule d'Alexander (cf. J. D. H. Alexander «Clock recovery from random binary signals » Electronics Letters 30 octobre 1975 vol. 11 n° 22). Ainsi, dans le mode de réalisation représenté figure 2, le détecteur avance-retard 26 est formé d'une cellule d'Alexander basée sur un double échantillonnage du signal reçu, une première fois en phase avec le signal d'horloge de réception H, une seconde fois en quadrature avec ce signal. Ce détecteur avance-retard 26 comprend ainsi un premier étage de deux bascules D 61, 62, recevant le signal reçu et le signal d'horloge de réception H, une porte de décalage en quadrature 65 étant interposée en entrée de la deuxième bascule D 62 du premier étage sur sa borne recevant le signal d'horloge. Le détecteur 26 comprend un deuxième étage de deux bascules D 63, 64 et deux portes OU exclusif 66, 67 pour former les signaux représentatifs du décalage de phase. La sortie de la première bascule 61 du premier étage fournit un signal DI(n) représentatif de l'échantillonnage en phase d'un bit n du signal reçu. La sortie de la première bascule 63 du deuxième étage relié à la suite de la première bascule 61 du premier étage, fournit un signal DI(n-1) représentatif de l'échantillonnage en phase du bit n-1 précédant immédiatement ledit bit n dans le signal reçu. La sortie de la deuxième bascule 62 du premier étage fournit un signal DQ(n+1/2) représentatif de l'échantillonnage en quadrature entre les bits de données n et n+1. La sortie de la deuxième bascule 64 du deuxième étage fournit un signal DQ(n-1/2) représentatif de l'échantillonnage en quadrature entre les bits de données n et n-1. Deux bascules D 68, 69 sont par ailleurs prévues pour former un registre de sortie permettant de synchroniser les signaux sur l'horloge de réception.

La table 1 suivante est une table de vérité d'un exemple de tel détecteur avance-retard 26 :

**TABLE 1 :**

| DI (n-1) | DQ (n-½) | DI (n) | E | L | Signification |
|---|---|---|---|---|---|
| 0 | 0 | 0 | 0 | 0 | en phase |
| 0 | 0 | 1 | 1 | 0 | avance |
| 0 | 1 | 0 | 1 | 1 | impossible |
| 0 | 1 | 1 | 0 | 1 | retard |
| 1 | 0 | 0 | 0 | 1 | retard |
| 1 | 0 | 1 | 1 | 1 | impossible |
| 1 | 1 | 0 | 1 | 0 | avance |
| 1 | 1 | 1 | 0 | 0 | en phase |

Il est à noter que le détecteur numérique de phase formé par le détecteur avance-retard 26 permet de détecter uniquement l'existence d'un décalage de phase et son sens, mais non l'amplitude de ce décalage de phase.

Les deux sorties 33a, 33b du détecteur avance-retard 26 sont reliées respectivement à deux entrées 32a, 32b d'un circuit convertisseur décisionnel 30 de la boucle d'asservissement en phase, dont un exemple de réalisation est donné figure 3. Ce circuit convertisseur décisionnel 30 permet de délivrer sur une sortie numérique parallèle à deux bornes 31a, 31b un signal numérique, dit signal d'états de phase filtré, à trois états en fonction des valeurs prises par le signal d'état de phase, c'est-à-dire les signaux d'avance E et de retard L délivrés pour chaque bit de données du signal reçu par le convertisseur avance-retard 26.

Le convertisseur décisionnel 30 ne modifie la valeur du signal d'états de phase filtré délivré sur sa sortie numérique parallèle que lorsqu'il reçoit successivement un nombre prédéfini de valeurs identiques sur ses entrées 32a, 32b, correspondant à un nombre prédéfini de bits de données successifs du signal reçu pour lesquels le détecteur avance-retard 26 a détecté un décalage de phase dans le même sens.

Le signal d'états de phase filtré est par exemple un signal binaire signé codé sur deux bits a0 et a1, chaque bit correspondant à l'une des deux bornes de sortie 31a, 31b. Lorsque les décalages de phase des bits de données successifs détectés sont dans un premier sens, par exemple lorsque le signal d'horloge de réception H est en avance, le signal d'états de phase filtré est égal à 1, codé par les valeurs a0 = 1, et a1 = 0. Lorsque les décalages de phase des bits de données successifs détectés sont dans l'autre sens, par exemple lorsque le signal d'horloge de réception H est en retard, le signal d'états de phase filtré est égal à -1, codé par les valeurs a0 = a1 = 1. Lorsque les bits de données sont en phase, le signal d'états de phase filtré est nul, codé par les valeurs a0 = a1 = 0.

En conséquence, le convertisseur décisionnel 30 a pour fonction de réaliser un filtrage des variations du décalage de phase détectées par le détecteur 26 afin de ne prendre en compte que les décalages de phase qui se reproduisent sur un nombre N supérieur à 1 de bits de données successifs du signal reçu. Le convertisseur décisionnel 30 a également pour fonction de convertir les signaux d'états de phase E et L en signaux d'états de phase filtrés a0 et a1.

Ce convertisseur décisionnel 30 comprend tout d'abord un étage de deux bascules D permettant de mémoriser les états E(n-1), L(n-1) de chacun des signaux E et, respectivement L reçus sur ses entrées 32a, 32b pour un bit n-1 par rapport à l'état E(n), L(n) de ces signaux pour un bit n immédiatement successif. Le convertisseur décisionnel 30 comprend en outre deux étages de portes ET 72, 73 et une porte OU 74 permettant, dans l'exemple représenté, de détecter les états de chacun des signaux E et, respectivement L, reçus sur ses entrées 32a, 32b, restant identiques sur deux bits de données successifs. Il suffit de multiplier les bascules D d'entrée et les portes ET pour augmenter le nombre de bits de données successifs pris en compte par le convertisseur décisionnel.

Deux bascules D 75, 76 sont par ailleurs prévues pour former un registre de sortie permettant de synchroniser les signaux a0, a1 délivrés sur les bornes de sortie 31a, 31b du convertisseur décisionnel 30 sur l'horloge de réception.

La table 2 suivante est une table de vérité d'un exemple de convertisseur décisionnel 30 pour lequel N=2 :

**TABLE 2 :**

| E(n) | E₍ₙ₋₁₎ | L(n) | L₍ₙ₋₁₎ | a₁ | a₀ | Valeur relative du signal de comptage/ décomptage | Observations |
|---|---|---|---|---|---|---|---|
| 0 | 0 | 0 | 0 | 0 | 0 | +0 | |
| 1 | 0 | 0 | 0 | 0 | 0 | +0 | 1 " cycle où E= 1 |
| 1 | 1 | 0 | 0 | 0 | 1 | +1 | 2^{eme} cycle successif où E=1 |
| 1 | 1 | 0 | 0 | 0 | 1 | +1 | 3^{ème} cycle successif où E=1 |
| 0 | 1 | 0 | 0 | 0 | 0 | +0 | 1" cycle où E repasse à 0 |
| 0 | 0 | 0 | 0 | 0 | 0 | +0 | |
| 0 | 0 | 1 | 0 | 0 | 0 | +0 | 1^{er} cycle où L=1 |
| 0 | 0 | 1 | 1 | 1 | 1 | -1 | 2^{ème} cycle successif où L=1 |
| 0 | 0 | 1 | 1 | 1 | 1 | -1 | 3^{éme} cycle successif où L=1 |
| 0 | 0 | 0 | 1 | 0 | 0 | +0 | 1^{er} cycle où L repasse à 0 |
| 0 | 0 | 0 | 0 | 0 | 0 | +0 | |

Les deux bornes de sortie 31a, 31b du convertisseur décisionnel 30 sont reliées à deux bornes d'entrée 34a, 34b d'un additionneur 35 de la boucle d'asservissement en phase. Cet additionneur 35 est adapté pour cumuler les valeurs relatives + 1, 0, - 1 du signal d'états de phase filtré. Dans l'exemple décrit, l'additionneur 35 présente une sortie parallèle 36 sur 8 bits sur laquelle le résultat du cumul est appliqué. Selon l'invention, tous les bits de la sortie 36 ne sont pas utilisés pour commander l'oscillateur 19. En effet, seuls les bits de poids forts 36a du signal délivré sur la sortie parallèle 36 sont utilisés pour constituer le signal numérique parallèle de commande délivré par l'additionneur 35 à l'oscillateur 19. Les bits de poids faibles 36b, qui sont en réalité représentatifs uniquement du bruit de phase relatif (« jitter ») ne sont pas utilisés. Dans l'exemple représenté, les 5 bits de poids forts sont utilisés à titre de signal de commande de l'oscillateur 19. De ce fait, en utilisant qu'une partie des bits de poids forts du signal en sortie de l'additionneur 35, on réalise un filtrage par intégration continue du signal fourni par le détecteur numérique de phase 26, 30.

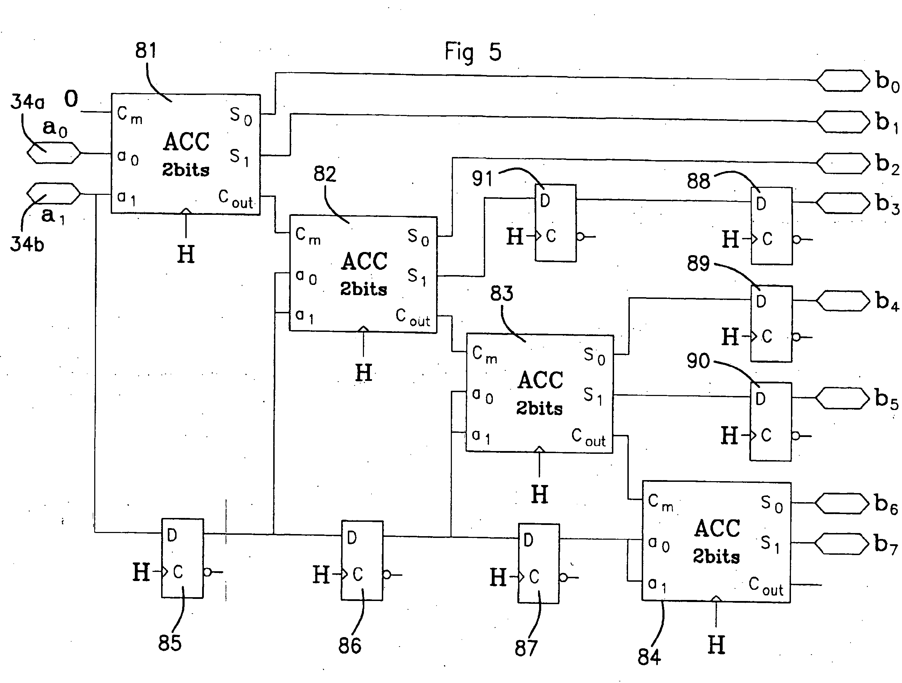

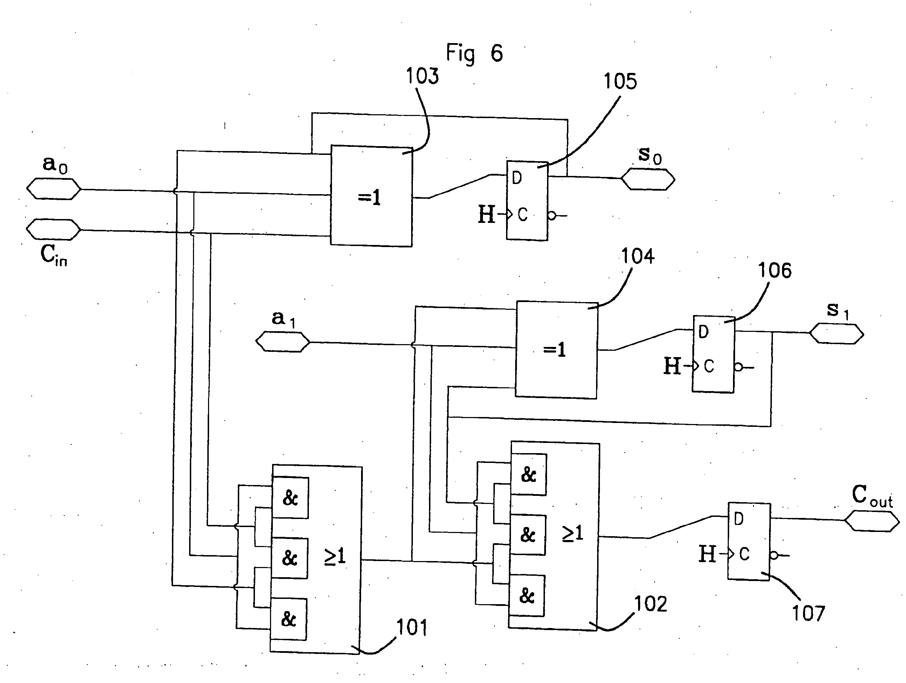

La figure 5 représente un exemple de réalisation d'un tel additionneur 35 formé d'une cascade de quatre accumulateurs 2 bits 81, 82, 83, 84 en série. La figure 6 représente un exemple de réalisation d'un accumulateur 2 bits pouvant être utilisé dans l'additionneur de la figure 5. Un tel accumulateur 2 bits est constitué de deux portes ET/OU 101,102 et de deux portes OU exclusif 103,104 à trois entrées. Trois bascules D 105, 106, 107 constituent un registre de sortie.

Dans l'additionneur 35, les quatre accumulateurs 2 bits 81, 82, 83, 84 sont assemblés selon une architecture pipeline comprenant trois bascules D 85, 86, 87 de synchronisation et un registre de sortie formé par trois bascules D 88, 89, 90, par les bascules de sortie 105, 106 du premier accumulateur 2 bits 81, par la bascule de sortie 105 du second accumulateur 2 bits 82, et par les bascules de sortie 105, 106 du dernier accumulateur 2 bits 84. L'additionneur 8 bits permet de délivrer en sortie un signal cumulé sur 8 bits b0, b1, b2, b3, b4, b5, b6, b7. Dans l'exemple décrit, seuls les bits de poids forts b3, b4, b5, b6, b7 sont délivrés à l'oscillateur verrouillé en injection 19. Il va de soi que toute autre structure d'additionneur 8 bits connue présentant les mêmes fonctions peut être utilisée dans le cadre de l'invention.

Il est à noter que la boucle 25 d'asservissement en phase d'un dispositif selon l'invention présente des propriétés d'auto-adaptation au niveau du bruit de phase du signal reçu puisque le gain de cette boucle d'asservissement en phase diminue lorsque l'écart type du bruit de phase augmente, ce qui entraîne de fait une réduction de la bande passante globale du filtre.

Le double filtrage numérique réalisé par le convertisseur décisionnel 30 d'une part et par la suppression des bits de poids faibles en sortie de l'additionneur 35, d'autre part, permet de s'affranchir de l'utilisation d'un filtre de boucle analogique.

Dans un dispositif selon l'invention, aucun réglage externe manuel n'est nécessaire en ce qui concerne la fréquence propre fos de l'oscillateur 19. En outre, quel que soit le signal reçu, la boucle d'asservissement en phase 25 permet d'assurer que le signal d'horloge de réception H fourni par l'oscillateur 19 soit toujours en phase avec le signal reçu.

Dans ces conditions, dans un dispositif selon l'invention, les décalages de phase dus aux délais de propagation dans les différentes branches du circuit sont tous connus et constants et peuvent donc être compensés par un (ou plusieurs) circuit(s) déphaseur(s) 37 placé(s) entre le noeud de dérivation 11 et chacune des entrées 17, 18 du circuit d'échantillonnage 15. Il est en effet important que le circuit d'échantillonnage 15 réalise un échantillonnage du signal reçu dans la zone centrale de la période de chaque bit de donnée du signal reçu où la valeur de la tension correspondante est la plus stable et où la marge de bruit est la plus grande, et ce afin d'éviter de réaliser l'échantillonnage sur le début ou la fin de la période de chaque bit où la tension du signal, en cours d'établissement, est soumise à une dérive de phase (traditionnellement désignée « jitter »). Dans le signal reçu, généralement bruité, chaque bit se présente sous forme d'un « oeil » compte tenu de la dérive de phase (« jitter »). L'échantillonnage doit se produire au centre de l'oeil.

Or, la différence entre la fréquence d'horloge bits fsr des bits reçus et la fréquence d'oscillation fos de l'oscillateur 19 étant nulle dans un dispositif selon l'invention, et l'ensemble des retards pouvant être introduits par les autres composants du circuit et l'ensemble des délais de propagation dans les différentes branches du circuit étant maîtrisés et connus, il est possible de déterminer le retard différentiel de phase structurel et constant entre les données contenues dans le signal reçu et le signal d'horloge de réception H délivré par l'oscillateur 19. Ce retard différentiel est compensé par le (les) circuit(s) déphaseur(s) 37.

Un seul circuit déphaseur 37 peut être prévu dans le dispositif selon l'invention, à tout endroit approprié. En variante, le déphasage entre les deux branches 12, 14 peut être obtenu par une pluralité de circuits déphaseurs 37 répartis en plusieurs endroits de chaque branche. Dans ce dernier cas, le cumul des déphasages introduits par chaque circuit déphaseur 37 est égal au déphasage total qui doit être réalisé entre les deux branches 12, 14.

Sur la figure 1 sont représentés en pointillés différents emplacements possibles auxquels un circuit déphaseur 37 peut être prévu. Ainsi, on peut prévoir un circuit déphaseur 37a entre le noeud de dérivation 11 et l'entrée de signal 17 du circuit d'échantillonnage 15 ; un circuit déphaseur 37b entre la sortie 29 de l'oscillateur 19 et l'entrée d'horloge 18 du circuit d'échantillonnage 15 ; un circuit déphaseur 37c entre le noeud de dérivation 11 et l'entrée 21 du générateur d'impulsions 20 alimentant l'oscillateur 19 ; un circuit déphaseur 37d entre la sortie 22 du générateur d'impulsions 20 et l'entrée 23 de l'oscillateur 19 ; un circuit déphaseur 37e entre le noeud de dérivation 11 et la deuxième entrée 28 du détecteur avance-retard 26 ; un circuit déphaseur 37f entre la sortie 29 de l'oscillateur 19 et la première entrée 27 du détecteur avance-retard 26. Chaque circuit déphaseur 37 peut être formé d'une simple ligne retard.

L'architecture d'un dispositif selon l'invention est intrinsèquement très peu sensible aux évènements transitoires tels que les changements d'état d'un signal dus à une particule ionisante une fois que l'oscillateur 19 est en mode verrouillé. En effet, la synchronisation de l'oscillateur sur le rythme du signal reçu permet de masquer les perturbations d'origine externe.

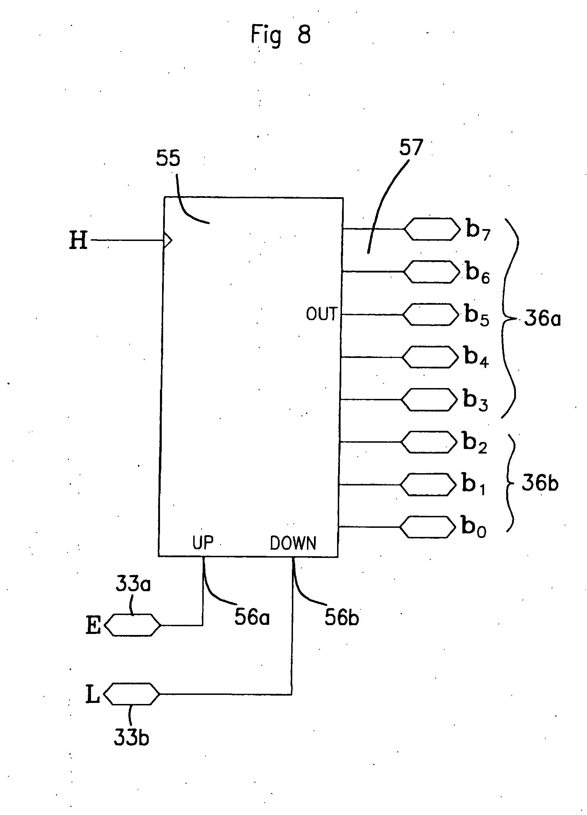

La figure 8 représente un deuxième mode de réalisation d'un circuit de comptage pouvant être utilisé dans un dispositif selon l'invention. Ce deuxième mode de réalisation diffère du précédent en ce que le convertisseur décisionnel 30 et le circuit additionneur 35 sont remplacés par un composant de circuit unique compteur/décompteur 55 qui présente une sortie 57 sur 8 bits et reçoit en entrée directement le signal d'états de phase délivré par le détecteur de phase 26, à savoir le signal d'avance de phase E sur son entrée 56a de comptage («UP») reliée à la première sortie 33a du détecteur avance-retard 26, et le signal de retard de phase L sur son entrée 56b de décomptage («DOWN ») reliée à la deuxième sortie 33b du détecteur avance - retard 26. Le compteur/décompteur 55 est cadencé par le signal d'horloge de réception H. Il est choisi de telle sorte que la valeur de sa sortie 57 reste non modifiée lorsque les valeurs présentées sur ses entrées 56a et 56b sont inactives.

Un niveau unique de filtrage est obtenu par le fait que, comme dans le premier mode de réalisation précédent, seule une partie (b3, b4, b5, b6, b7 dans l'exemple représenté) des bits de poids forts du signal de sortie délivré par le compteur/décompteur 55 est utilisée pour former l'entrée de commande de l'oscillateur 19.

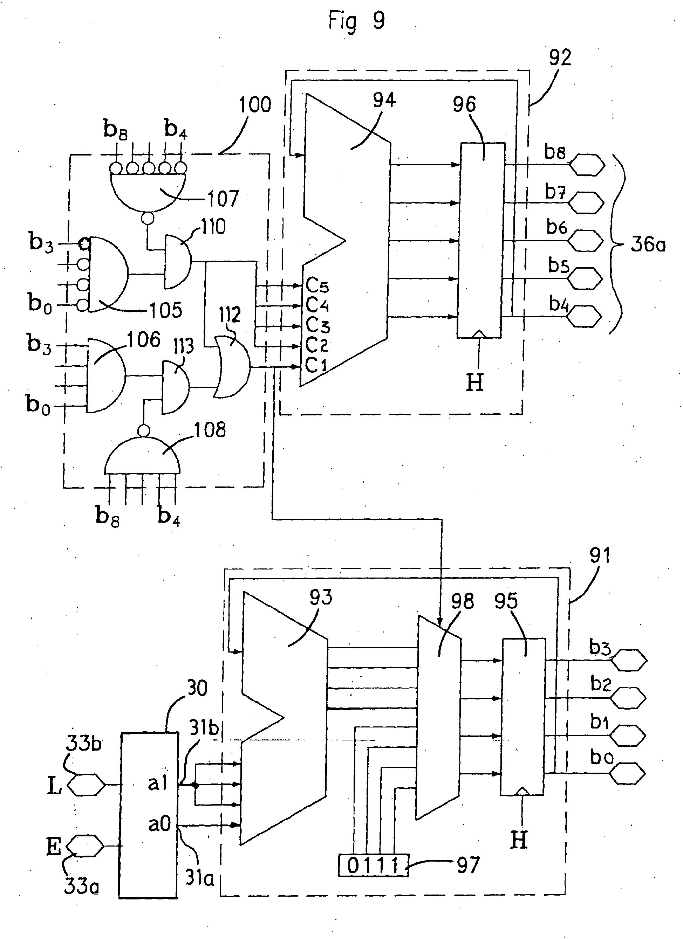

Le troisième mode de réalisation représenté figure 9 diffère du premier mode de réalisation par le fait que le circuit additionneur 35 est remplacé par deux étages additionneurs 91, 92, dont un premier étage additionneur 91 de niveau bas fournissant en sortie des bits de poids faibles, à savoir 4 bits de poids faibles b0, b1, b2, b3 dans l'exemple représenté, du signal de comptage/décomptage et un deuxième étage additionneur 92 de niveau haut fournissant en sortie des bits de poids forts, à savoir 5 bits de poids forts b4, b5, b6, b7, b8 dans l'exemple représenté, du signal de comptage/décomptage.

Le premier étage additionneur 91 comprend un circuit additionneur 93 comprenant deux entrées numériques parallèles de 4 bits fournissant sur une sortie numérique 4 bits la somme des deux entrées. La première entrée de ce circuit additionneur 93 est alimentée à partir du signal d'états de phase E, L par les sorties 33a, 33b du détecteur avance-retard 26 via le convertisseur décisionnel 30. La sortie 31b du convertisseur décisionnel 30 délivrant le signal d'états de phase filtré a1 est reliée à trois entrées de l'additionneur 93. Si E=1, le convertisseur décisionnel 30 délivre le signal 0001 (correspondant à la valeur relative +1) à l'entrée du circuit additionneur 93. Si L=1, le convertisseur décisionnel 30 délivre le signal 1111 (correspondant à la valeur relative -1) à l'entrée du circuit additionneur 93. La sortie du circuit additionneur 93 est reliée à l'entrée d'un multiplexeur 98 qui reçoit également en entrée une valeur enregistrée dans un registre 97 de 4 bits. Cette valeur est de préférence une valeur médiane, c'est-à-dire une valeur à partir de laquelle il faut compter un même nombre de variations (non nécessairement immédiatement successives) dans un sens ou dans l'autre pour déclencher une modification de la valeur de l'entrée de commande de l'oscillateur 19, c'est-à-dire du signal en sortie du deuxième étage additionneur 92. Dans l'exemple représenté, le registre 97 contient la valeur 0111, de sorte que le signal de commande ne sera modifié qu'à partir de la détection d'un déséquilibre de 7 ou 8 états dans le même sens (ou un autre nombre selon la valeur contenue dans le registre 97).

La sortie du multiplexeur 98 est une sortie sur 4 bits parallèles délivrés à un registre 95 cadencé par le signal d'horloge de réception H. Ce registre 95 fournit les bits de sortie de poids faibles b0, b1, b2, b3, qui sont délivrés à la deuxième entrée du circuit additionneur 93 par un rebouclage.

Le deuxième étage additionneur 92 comprend un circuit additionneur 94 sur 5 bits alimenté par un circuit 100 de calcul de retenue détectant les valeurs extrêmes (inférieure nulle et supérieure) de la sortie de poids faibles b0, b1, b2, b3. Ce circuit 100 de calcul de retenue permet d'alimenter une entrée 5 bits du circuit additionneur 94 avec un signal numérique parallèle constituant 5 bits de poids forts par rapport à la sortie b0, b1, b2, b3 de poids faible du premier étage additionneur 91. Pour ce faire, le signal de sortie b0, b1, b2, b3 de poids faibles est délivré à l'entrée de deux portes 105, 106 du circuit 100 de calcul de retenue. La sortie de la porte ET 105 est égale à 1 lorsque tous les bits b0, b1, b2, b3 sont égaux à 0. Elle est égale à 0 lorsque l'un au moins des bits b0, b1, b2, b3 est égal à 1. La sortie de la porte 105 est reliée à l'entrée d'une porte ET 110 dont la sortie est appliquée sur quatre bits de poids forts c2, c3, c4, c5 de l'une des deux entrées du circuit additionneur 94 du deuxième étage 92. La sortie de la porte 106 est égale à 1 lorsque tous les bits b0, b1, b2, b3 sont égaux à 1. Elle est égale à 0 lorsque l'un au moins des bits b0, b1, b2, b3 est égal à 0. La sortie de la porte 106 est reliée à l'entrée d'une porte ET 113 dont la sortie est reliée à l'entrée d'une porte OU 112, la sortie de cette dernière formant le bit c1 de poids faible de la même entrée du circuit additionneur 94 du deuxième étage 92. Par ailleurs, la sortie de la porte 110 est reliée à la deuxième entrée de la porte OU 112.

Lorsque les bits b0, b1, b2, b3 sont tous égaux à 0, la sortie de la porte 105 est égale à 1, et, si la porte 110 l'autorise, il en va de même des bits de poids forts c2, c3, c4, c5 de l'entrée du circuit additionneur 94 ainsi que de l'une des entrées de la porte 112. Donc, la sortie de la porte 112 est égale à 1, et il en va de même du bit c1 de poids faible de l'entrée du circuit additionneur 94. En conséquence, dans cette situation, l'entrée c1, c2, c3, c4, c5 du circuit additionneur 94 du deuxième étage est égale à 11111, correspondant à la valeur relative -1 commandant une décrémentation d'une unité du registre 96.

De même, lorsque les bits b0, b1, b2, b3 sont tous égaux à 1, la sortie de la porte 106 est égale à 1, et, si la porte 113 l'autorise, il en va de même du bit c1 de poids faible de l'entrée du circuit additionneur 94. Simultanément, la sortie de la porte 105 est égale à 0, et il en va de même des bits de poids forts c2, c3, c4, c5 de l'entrée du circuit additionneur 94. En conséquence, dans cette situation, l'entrée c1, c2, c3, c4, c5 du circuit additionneur 94 du deuxième étage est égale à 00001, correspondant à la valeur relative +1 commandant une incrémentation d'une unité du registre 96.

Tant que l'un des bits b0, b1, b2, b3 est égal à 0 et que l'un des bits b0, b1, b2, b3 est égal à 1, c'est-à-dire lorsque la sortie de poids faible du premier étage additionneur 91 a une valeur qui ne correspond pas à l'une des valeurs extrêmes, les sorties des deux portes 105, 106 sont toutes les deux égales à zéro, de sorte que l'entrée c1, c2, c3, c4, c5 du circuit additionneur 94 du deuxième étage est égale à 00000, de sorte que la valeur du registre 96 n'est pas modifiée.

Ainsi, dès qu'une valeur extrême du signal de sortie b0, b1, b2, b3 de poids faibles est atteinte, d'une part le contenu du registre 96 est incrémenté ou décrémenté, car les portes 105 ou 106 permettent de propager la valeur relative +1 ou -1 devant l'entrée c1, c2, c3, c4, c5 de l'additionneur 94, et, d'autre part, le bit c1 de poids faible de l'entrée du circuit additionneur 94 étant égal à 1, cette valeur +1 ou -1 active le signal de contrôle du multiplexeur 98 qui force le rechargement du registre 95 avec la valeur contenue dans le registre 97.

Ainsi, on garantit qu'il est nécessaire qu'il se produise un décalage de phase de 7 ou 8 états dans le même sens à partir de la valeur médiane enregistrée dans le registre 97 pour que le signal de commande délivré sur la sortie 36a soit effectivement modifié.

Le circuit additionneur 94 présente une sortie sur 5 bits b4, b5, b6, b7, b8 mémorisés dans un registre 96 cadencé sur le signal d'horloge de réception H, la sortie de ce registre constituant la sortie 36aa alimentant l'entrée de commande de l'oscillateur numérique 19.

La sortie du registre 96 est également fournie à la deuxième entrée du circuit additionneur 94 par un rebouclage. Par ailleurs, le circuit 100 de calcul de retenue permet également, si la dynamique du système le nécessite, d'éviter les variations intempestives du signal sur la sortie 36a de poids forts lorsque la valeur de ce signal atteint une valeur extrême. Pour ce faire, le circuit 100 de calcul de retenue comprend deux portes 107, 108 recevant les valeurs des bits de poids forts b4, b5, b6, b7, b8 de la sortie 36a, et le circuit 100 de calcul de retenue est adapté pour interdire l'incrémentation d'une unité lorsque le signal sur les bits b4, b5, b6, b7, b8 est égal à 11111 et la décrémentation d'une unité lorsque le signal sur les bits b4, b5, b6, b7, b8 est égal à 00000. Cette fonction est obtenue par les portes 110, 113 qui reçoivent en entrée les sorties des portes 107, respectivement 108. Lorsque les bits b4, b5, b6, b7, b8 prennent la valeur maximum 11111, la sortie de la porte 108 est égale à 0, de sorte que la sortie de la porte 113 est forcée à zéro ; la sortie de 105 étant par ailleurs égale à 0, l'entrée c1, c2, c3, c4, c5 du circuit additionneur 94 reste égale à 0, interdisant l'incrémentation d'une unité du registre 96. De même, lorsque les bits b4, b5, b6, b7, b8 prennent la valeur minimum 00000, la sortie de la porte 107 est égale à 0, de sorte que la sortie de la porte 110 est forcée à 0, ainsi que les bits de poids forts c2, c3, c4, c5 de l'entrée du circuit additionneur 94, l'entrée c1 du circuit additionneur étant par ailleurs égal à 0, interdisant la décrémentation d'une unité du registre 96.

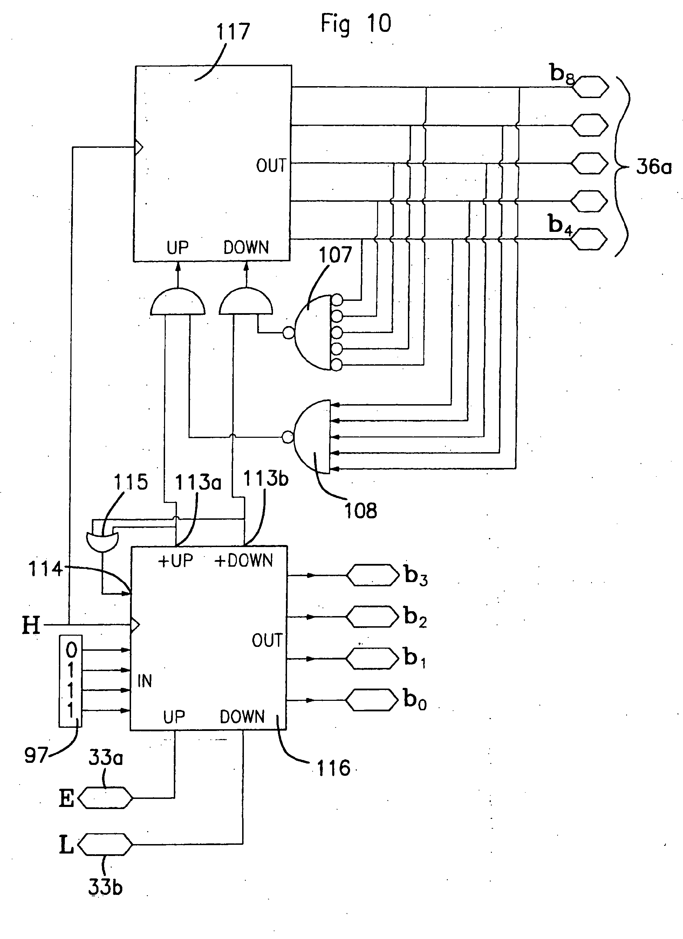

La figure 10 représente un quatrième mode de réalisation similaire fonctionnellement à celui de la figure 9 mais réalisé en remplaçant les additionneurs 93, 94 par des compteurs/décompteurs 116, 117. Le premier compteur 116 reçoit les signaux E et L d'états de phase sur ses entrées de comptage et, respectivement de décomptage. Il présente une entrée IN 4 bits recevant la valeur médiane enregistrée dans le registre 97. Sa sortie OUT fournit le signal de sortie b0, b1, b2, b3 de poids faibles. Il présente également des sorties de retenue 113a supérieure et, respectivement, 113b inférieure, ainsi qu'une entrée de commande 114 de rechargement de son entrée IN. La sortie de retenue 113a supérieure est active lorsque l'entrée de comptage est incrémentée d'une unité et que la sortie OUT est à sa valeur maximum 1111. De même, la sortie de retenue 113b inférieure est active lorsque l'entrée de décomptage est incrémentée d'une unité et que la sortie OUT est à sa valeur minimum 0000.

Les sorties de retenue 113a supérieure et 113b inférieure, alimentent les entrées de comptage et de décomptage, respectivement du deuxième compteur/décompteur 117. De plus, une porte 115 détecte un état actif de ces deux sorties de retenue 113a supérieure et 113b inférieure et impose un rechargement de l'entrée IN du premier compteur 116 lorsqu'une de ces sorties retenue 113a supérieure et 113b inférieure est active. De la sorte, le premier compteur 116 est réinitialisé à la valeur médiane contenue dans le registre 97 dès que la sortie b0, b1, b2, b3 de poids faible a dépassé une de ses valeurs extrêmes. On assure donc là encore qu'il soit nécessaire de constater un décalage de phase pour au moins 8 ou 9 (ou un autre nombre selon la valeur contenue dans le registre 97) états successifs à partir de l'une des valeurs extrêmes de la sortie b0, b1, b2, b3 de poids faibles, pour modifier la valeur de la sortie 36a de poids forts.

Le deuxième compteur/décompteur 117 présente une sortie sur 5 bits parallèles formant la sortie 36a de poids forts alimentant l'entrée de commande de l'oscillateur 19. Comme dans le mode de réalisation précédent, il est prévu des portes 107, 108 recevant les valeurs des bits de poids forts b4, b5, b6, b7, b8 de la sortie 36a, et adaptées pour interdire l'incrémentation d'une unité lorsque le signal sur les bits b4, b5, b6, b7, b8 est égal à 11111 et la décrémentation d'une unité lorsque le signal sur les bits b4, b5, b6, b7, b8 est égal à 00000.

Dans un dispositif selon l'invention, l'oscillateur verrouillé en injection est adapté pour qu'un incrément du signal numérique de commande entraîne une modification de la fréquence propre de l'oscillateur selon un pas de valeur Δf prédéterminée. Le choix du nombre de bits retenus pour former le bus du signal de commande à partir de la sortie parallèle du circuit accumulateur, et le choix du pas de réglage Δf dépendent de la dynamique requise pour la boucle d'asservissement de phase 25. Par exemple, pour une fréquence propre de l'oscillateur 19 verrouillé en injection de l'ordre de 10 GHz, avec un pas Δf inférieur à 1 % -et notamment de l'ordre de 0,3 %-, chaque incrément d'une unité du signal numérique de commande entraîne une variation de l'ordre de 30 MHz de cette fréquence propre. Par ailleurs, dans le même exemple, si le signal de commande de l'oscillateur 19 comprend, comme dans les exemples décrits, 5 bits, ce signal permet de réaliser trente-deux incréments, et procure donc une plage de réglage de la fréquence propre fos de l'oscillateur 19 verrouillé en injection de l'ordre de 10 %, c'est-à-dire de l'ordre de 1 GHz.

### EXEMPLE

On a réalisé un prototype d'un dispositif conforme au premier mode de réalisation de l'invention sous forme d'un circuit ASIC en technologie CMOS 0,13 µm de chez STMicroelectronics. Ce prototype encapsulé en boîtier a été reporté sur un circuit imprimé verre-téflon, ce qui a permis de valider l'ensemble du fonctionnement de cette architecture qui a passé avec succès une caractérisation électrique complète.

L'invention peut faire l'objet de très nombreuses variantes de réalisation par rapport aux exemples de réalisation représentés sur les figures et décrits ci-dessus. En particulier, les différents composants du dispositif (détecteur avance-retard, convertisseur décisionnel, circuit de comptage, oscillateur, générateur d'impulsions....) peuvent être réalisés par d'autre structures de circuit, connues en elles-mêmes, et procurant les mêmes fonctions. Par exemple, les circuits 100, 107, 108 peuvent faire l'objet d'autres implémentations (avec d'autres types de portes logiques ou d'autres combinaisons de portes logiques) que celles données à titre d'exemple, et ayant les mêmes fonctions techniques.

## Revendications

1. Dispositif d'extraction d'horloge à partir d'un signal série en bande de base, dit signal reçu, représentatif de données numériques et codé avec un signal d'horloge présentant une fréquence d'horloge bits fsr, comprenant :
- un circuit (19) recevant un signal issu du signal reçu et cadencé à la fréquence d'horloge bits fsr, et délivrant, sur au moins une sortie d'horloge (29), un signal d'horloge, dit signal d'horloge de réception, au moins sensiblement synchronisé et en phase avec la fréquence d'horloge bits fsr du signal reçu,
- une boucle d'asservissement en phase (25) comprenant :
- une première entrée (27) reliée à une sortie d'horloge (29) du circuit (19) délivrant un signal d'horloge de réception,
- une deuxième entrée (28) alimentée par un signal issu du signal reçu,
- un détecteur (26) numérique de phase comprenant un détecteur avance-retard relié aux première et deuxième entrées (27, 28) et adapté pour délivrer, sur au moins une sortie (33a, 33b), au moins un signal numérique, dit signal d'états de phase, représentatif d'un décalage de phase entre le signal d'horloge de réception et le signal reçu, et du sens de ce décalage,
- une sortie (36a) délivrant un signal, dit signal de commande, reliée à une entrée, dite entrée de commande, du circuit (19) délivrant un signal d'horloge de réception, adaptée pour que la valeur de la fréquence du signal d'horloge de réception dépende de la valeur du signal de commande reçu sur cette entrée de commande,
- un circuit, dit circuit de comptage (30, 35, 55, 91, 92, 116, 117), présentant une entrée reliée à ladite sortie (33a, 33b) du détecteur (26) numérique de phase, ledit circuit de comptage étant adapté pour réaliser au moins un filtrage par comptage/décomptage numérique sur les variations des valeurs relatives du signal numérique délivrées dans le temps par le détecteur (26) de phase, et pour délivrer un signal de commande sous forme numérique dont la valeur est fonction du résultat de ce filtrage ou de ces filtrages, cette valeur du signal de commande étant adaptée pour imposer une valeur de la fréquence du signal d'horloge de réception égale à une valeur ainsi filtrée de la fréquence d'horloge bits fsr du signal d'horloge de réception,
**caractérisé en ce que** :
- le circuit (19) délivrant un signal d'horloge de réception est un oscillateur (19) verrouillé en injection à commande numérique, comprenant une entrée de commande numérique adaptée pour pouvoir recevoir le signal de commande délivré par la boucle d'asservissement en phase (25) sous forme numérique, et pour que la valeur de la fréquence propre fos de l'oscillateur (19) dépende de la valeur du signal de commande reçu sur cette entrée de commande,
- la boucle d'asservissement en phase (25) comprend un circuit (30) présentant au moins une entrée (32a, 32b) reliée respectivement à la sortie ou aux sorties du détecteur (26) avance-retard, et délivrant sur au moins une sortie (31a, 31b), un signal numérique, dit signal d'états de phase filtré :
- ayant une première valeur relative après réception d'un nombre prédéterminé N supérieur à 1 de valeurs identiques successives en entrée, correspondant à N bits de données successifs du signal reçu pour lesquels le détecteur (26) avance-retard a détecté un décalage de phase dans le même sens,
- ayant une deuxième valeur relative après réception de N valeurs identiques successives en entrée, correspondant à N bits de données successifs du signal reçu pour lesquels le détecteur (26) avance-retard a détecté un décalage de phase dans l'autre sens,
- ayant une troisième valeur relative dans les autres cas,
de sorte que la valeur relative du signal d'états de phase filtré est représentative de la présence d'un décalage de phase dans le même sens, et du sens de ce décalage de phase, pour N bits de données successifs du signal reçu, entre les fronts du signal d'horloge de réception et les bits de données correspondants du signal reçu.

2. Dispositif selon la revendication 1, **caractérisé en ce que** le détecteur (26) avance-retard est adapté pour délivrer sur une première sortie (33a) un signal numérique (E) représentatif de la présence d'une avance de phase entre le signal horloge de réception et le signal reçu, et sur une deuxième sortie (33b) un signal numérique (L) représentatif de la présence d'un retard de phase entre le signal d'horloge de réception et le signal reçu.

3. Dispositif selon l'une des revendications 1 ou 2, **caractérisé en ce que** le détecteur (26) avance-retard est adapté pour échantillonner le signal reçu sur les fronts montants et descendants du signal d'horloge de réception.

4. Dispositif selon l'une des revendications 1 à 3, **caractérisé en ce que** le détecteur (26) avance-retard est adapté pour réaliser un double échantillonnage, l'un en phase avec les fronts du signal d'horloge de réception, l'autre en quadrature avec les fronts du signal horloge de réception de façon à déterminer l'état intermédiaire du signal reçu.

5. Dispositif selon l'une des revendications 1 à 4, **caractérisé en ce que** ledit circuit (30) délivrant le signal d'états de phase filtré est un convertisseur décisionnel (30).

6. Dispositif selon l'une des revendications 1 à 5, **caractérisé en ce que** ledit circuit de comptage comprend au moins un circuit, dit circuit accumulateur (35, 55, 91, 92, 116, 117), comprenant au moins une entrée (32a, 32b) recevant un signal numérique issu de chaque signal d'états de phase délivré par le détecteur (26) avance-retard, ce circuit accumulateur étant adapté pour délivrer un signal numérique, dit signal de comptage/décomptage, dont la valeur relative est représentative de la réception d'un cumul de valeurs relatives présentées sur l'entrée ou sur les entrées (32a, 32b) de ce circuit accumulateur.

7. Dispositif selon la revendication 6, **caractérisé en ce que** ledit circuit de comptage comprend successivement un convertisseur décisionnel (30) et un circuit accumulateur (35, 91, 92) adapté pour cumuler les valeurs relatives du signal d'états de phase filtré délivrée par le convertisseur décisionnel (30).

8. Dispositif selon la revendication 7, **caractérisé en ce que** le circuit accumulateur présente une sortie (36) parallèle, et est adapté pour délivrer sur cette sortie (36) parallèle un signal numérique parallèle de comptage/décomptage, et **en ce que** l'oscillateur (19) verrouillé en injection comprend une entrée numérique parallèle de commande comprenant un nombre de bits inférieur à celui de la sortie (36) numérique parallèle du circuit accumulateur, seuls une partie (36a) des bits de poids forts de la sortie (36) numérique parallèle du circuit accumulateur étant reliés aux bits de l'entrée numérique parallèle de commande de l'oscillateur (19) verrouillé en injection, de sorte que le dit signal de commande délivré par le circuit de comptage est formé de ladite partie (36a) des bits de poids forts dudit signal de comptage/décomptage.

9. Dispositif selon la revendication 8, **caractérisé en ce que** l'entrée numérique parallèle de l'oscillateur (19) verrouillé en injection comprend 5 bits, seuls les 5 bits de poids forts de la sortie (36) numérique parallèle du circuit accumulateur étant reliés aux 5 bits de l'entrée numérique parallèle de commande de l'oscillateur verrouillé en injection.

10. Dispositif selon l'une des revendications 1 à 9, **caractérisé en ce que** l'entrée numérique de commande de l'oscillateur (19) verrouillé en injection est reliée à un circuit comprenant une pluralité de commutateurs (45a, 45b, 45c, 45d, 45e), chaque commutateur étant relié en série avec au moins un condensateur intégré dans le circuit de l'oscillateur (19) de façon à modifier sa fréquence propre.

11. Dispositif selon les revendications 7 et 10, **caractérisé en ce que** chaque bit de l'entrée numérique de commande est relié à l'un des commutateurs.

12. Dispositif selon l'une des revendications 1 à 11, **caractérisé en ce que** le circuit d'extraction d'horloge comprend en outre un circuit, dit générateur (20) d'impulsions de synchronisation, générant un signal d'impulsions de courant à la fréquence de fronts du signal reçu, et adapté au fonctionnement de l'oscillateur (19) verrouillé en injection, ce générateur (20) d'impulsions de synchronisation étant adapté pour délivrer le signal d'impulsions de courant sur une sortie (22) unique reliée uniquement à une entrée (23) en courant de l'oscillateur (19) verrouillé en injection.

13. Dispositif selon l'une des revendications 1 à 12, d'extraction d'horloge et de données numériques, comprenant en outre un circuit (15) d'échantillonnage du signal reçu avec le signal d'horloge de réception, ce circuit (15) d'échantillonnage ayant une première entrée, dite entrée de signal (17), reliée à l'entrée de réception, et une deuxième entrée, dite entrée d'horloge (18), reliée à une sortie d'horloge (29) de l'oscillateur verrouillé en injection, ce circuit (15) d'échantillonnage étant adapté pour délivrer sur au moins une sortie (16) de données, des données numériques transmises par le signal reçu,
**caractérisé en ce qu'**il comprend au moins un circuit déphaseur (37a, 37b, 37c, 37d, 37e, 37f) adapté pour introduire une différence de phase constante entre l'entrée de signal (17) et l'entrée d'horloge (18) du circuit (15) d'échantillonnage, la différence de phase totale entre ces deux entrées (17, 18) résultant de chaque circuit déphaseur étant adaptée pour garantir un alignement en phase du signal à l'entrée de signal (17) et du signal à l'entrée d'horloge (18).

14. Dispositif selon l'une des revendications 1 à 13, **caractérisé en ce qu'**il est adapté pour pouvoir fonctionner avec une fréquence d'horloge bits fsr supérieure à 500 MHz.

## Patentansprüche

1. Vorrichtung zum Entnehmen eines Taktes aus einem seriellen Basisbandsignal, dem so genannten empfangenen Signal, das numerische Daten darstellt und mit einem Taktsignal codiert ist, das eine Bittaktfrequenz fsr aufweist, umfassend:
- eine Schaltung (19), die ein Signal empfängt, das aus dem empfangenen Signal stammt und auf der Bittaktfrequenz fsr getaktet ist, und an mindestens einem Taktausgang (29) ein Taktsignal, das so genannte Empfangstaktsignal, abgibt, das mindestens im Wesentlichen auf die Bittaktfrequenz fsr des empfangenen Signals synchronisiert und damit phasengleich ist,
- einen Phasenregelkreis (25), umfassend:
- einen ersten Eingang (27), der mit einem Taktausgang (29) der Schaltung (19) verbunden ist, die ein Empfangstaktsignal abgibt,
- einen zweiten Eingang (28), der von einem Signal gespeist wird, das aus dem empfangenen Signal stammt,
- einen digitalen Phasendetektor (26), der einen Vorschub/Verzögerungs-Detektor umfasst, der mit den ersten und zweiten Eingängen (27, 28) verbunden ist und geeignet ist, um an mindestens einem Ausgang (33a, 33b) mindestens ein digitales Signal abzugeben, das so genannte Phasenzustandssignal, das einen Phasenversatz zwischen dem Empfangstaktsignal und dem empfangenen Signal und die Richtung dieses Versatzes darstellt,
- einen Ausgang (36a), der ein Signal abgibt, das so genannte Steuersignal, und der mit einem Eingang, dem so genannten Steuereingang, der Schaltung (19) verbunden ist, der ein Empfangstaktsignal abgibt und der geeignet ist, damit der Wert der Frequenz des Empfangstaktsignals von dem Wert des Steuersignals abhängt, das an diesem Steuereingang empfangen wird,
- eine Schaltung, die so genannte Aufwärtszählschaltung (30, 35, 55, 91, 92, 116, 117), die einen Eingang aufweist, der mit dem Ausgang (33a, 33b) des digitalen Phasendetektors (26) verbunden ist, wobei die Aufwärtszählschaltung geeignet ist, um mindestens eine digitale Filterung durch digitales Auf-/Abwärtszählen an den Variationen der relativen Werte des digitalen Signals, die im Verlauf der Zeit von dem Phasendetektor (26) abgegeben werden, vorzunehmen, und um ein Steuersignal in digitaler Form abzugeben, dessen Wert von dem Ergebnis dieser Filterung(en) abhängig ist, wobei dieser Wert des Steuersignals geeignet ist, um einen Wert der Frequenz des Empfangstaktsignals gleich einem derart gefilterten Wert der Bittaktfrequenz fsr des Empfangstaktsignals vorzuschreiben,
**dadurch gekennzeichnet, dass**:
- die Schaltung (19), die ein Empfangstaktsignal abgibt, ein digital gesteuerter einspeisungsgekoppelter Oszillator (19) ist, der einen digitalen Steuereingang umfasst, der geeignet ist, um das Steuersignal empfangen zu können, das von dem Phasenregelkreis (25) in digitaler Form abgegeben wird, und damit der Eigenfrequenzwert fos des Oszillators (19) von dem Wert des Steuersignals abhängt, das an diesem Steuereingang empfangen wird,
- der Phasenregelkreis (25) eine Schaltung (30) umfasst, die mindestens einen Eingang (32a, 32b) aufweist, der jeweils mit dem Ausgang oder den Ausgängen des Vorschub/Verzögerungs-Detektors (26) verbunden ist und an mindestens einem Ausgang (31a, 31b) ein digitales Signal, das so genannte gefilterte Phasenzustandssignal, abgibt:
- das nach dem Empfang einer vorbestimmten Anzahl N größer als 1 von aufeinanderfolgenden identischen Eingangswerten, die N aufeinanderfolgenden Datenbits des empfangenen Signals entsprechen, für die der Vorschub/Verzögerungs-Detektor (26) einen Phasenversatz in der gleichen Richtung ermittelt hat, einen ersten relativen Wert aufweist,
- das nach dem Empfang von N aufeinanderfolgenden identischen Eingangswerten, die N aufeinanderfolgenden Datenbits des empfangenen Signals entsprechen, für die der Vorschub/Verzögerungs-Detektor (26) einen Phasenversatz in der anderen Richtung ermittelt hat, einen zweiten relativen Wert aufweist,
- das ansonsten einen dritten relativen Wert aufweist, so dass der relative Wert des gefilterten Phasenzustandssignals das Vorliegen eines Phasenversatzes in der gleichen Richtung und die Richtung dieses Phasenversatzes für N aufeinanderfolgende Datenbits des empfangenen Signals zwischen den Flanken des Empfangstaktsignals und den entsprechenden Datenbits des empfangenen Signals darstellt.

2. Vorrichtung nach Anspruch 1, **dadurch gekennzeichnet, dass** der Vorschub/Verzögerungs-Detektor (26) geeignet ist, um an einem ersten Ausgang (33a) ein digitales Signal (E), welches das Vorliegen eines Phasenvorschubs zwischen dem Empfangstaktsignal und dem empfangenen Signal darstellt, und an einem zweiten Ausgang (33b) ein digitales Signal (L), welches das Vorliegen einer Phasenverzögerung zwischen dem Empfangstaktsignal und dem empfangenen Signal darstellt, abzugeben.

3. Vorrichtung nach einem der Ansprüche 1 oder 2, **dadurch gekennzeichnet, dass** der Vorschub/Verzögerungs-Detektor (26) geeignet ist, um das empfangene Signal an den steigenden und fallenden Flanken des Empfangstaktsignals abzutasten.

4. Vorrichtung nach einem der Ansprüche 1 bis 3, **dadurch gekennzeichnet, dass** der Vorschub/Verzögerungs-Detektor (26) geeignet ist, um eine doppelte Abtastung auszuführen, eine in Phase mit den Flanken des Empfangstaktsignals, die andere in Quadratur mit den Flanken des Empfangstaktsignals, um den Zwischenzustand des empfangenen Signals zu bestimmen.

5. Vorrichtung nach einem der Ansprüche 1 bis 4, **dadurch gekennzeichnet, dass** die Schaltung (30), die das gefilterte Phasenzustandssignal abgibt, ein Entscheidungswandler (30) ist.

6. Vorrichtung nach einem der Ansprüche 1 bis 5, **dadurch gekennzeichnet, dass** die Aufwärtszählschaltung mindestens eine Schaltung umfasst, die so genannte Akkumulatorschaltung (35, 55, 91, 92, 116, 117), die mindestens einen Eingang (32a, 32b) umfasst, der ein digitales Signal, das aus jedem Phasenzustandssignal stammt, das von dem Vorschub/Verzögerungs-Detektor (26) abgegeben wird, empfängt, wobei diese Akkumulatorschaltung geeignet ist, um ein digitales Signal abzugeben, das so genannte Auf-/Abwärtszählsignal, dessen relativer Wert den Empfang einer Summierung relativer Werte darstellt, die an dem Eingang oder den Eingängen (32a, 32b) dieser Akkumulatorschaltung anliegen.

7. Vorrichtung nach Anspruch 6, **dadurch gekennzeichnet, dass** die Aufwärtszählschaltung nacheinander einen Entscheidungswandler (30) und eine Akkumulatorschaltung (35, 91, 92), die geeignet ist, um die relativen Werte des gefilterten Phasenzustandssignals, das von dem Entscheidungswandler (30) abgegeben wird, zu summieren, umfasst.

8. Vorrichtung nach Anspruch 7, **dadurch gekennzeichnet, dass** die Akkumulatorschaltung einen parallelen Ausgang (36) aufweist und geeignet ist, um an diesem parallelen Ausgang (36) ein paralleles digitales Auf-/Abwärtszählsignal abzugeben, und dass der einspeisungsgekoppelte Oszillator (19) einen parallelen digitalen Steuereingang umfasst, der eine Bitanzahl umfasst, die geringer ist als die des parallelen digitalen Ausgangs (36) der Akkumulatorschaltung, wobei nur ein Teil (36a) der werthohen Bits des parallelen digitalen Ausgangs (36) der Akkumulatorschaltung mit den Bits des parallelen digitalen Steuereingangs des einspeisungsgekoppelten Oszillators (19) verbunden ist, so dass das Steuersignal, das von der Aufwärtszählschaltung abgegeben wird, aus dem Teil (36a) der werthohen Bits des Auf-/Abwärtszählsignals gebildet ist.

9. Vorrichtung nach Anspruch 8, **dadurch gekennzeichnet, dass** der parallele digitale Eingang des einspeisungsgekoppelten Oszillators (19) 5 Bits umfasst, wobei nur die 5 werthohen Bits des parallelen digitalen Ausgangs (36) der Akkumulatorschaltung mit den 5 Bits des parallelen digitalen Steuereingangs des einspeisungsgekoppelten Oszillators verbunden sind.

10. Vorrichtung nach einem der Ansprüche 1 bis 9, **dadurch gekennzeichnet, dass** der digitale Steuereingang des einspeisungsgekoppelten Oszillators (19) mit einer Schaltung verbunden ist, die eine Vielzahl von Schaltern (45a, 45b, 45c, 45d, 45e) umfasst, wobei jeder Schalter mit mindestens einem Kondensator in Reihe geschaltet ist, der in der Oszillatorschaltung (19) integriert ist, um seine Eigenfrequenz zu ändern.

11. Vorrichtung nach Anspruch 7 und 10, **dadurch gekennzeichnet, dass** jedes Bit des digitalen Steuereingangs mit einem der Schalter verbunden ist.

12. Vorrichtung nach einem der Ansprüche 1 bis 11, **dadurch gekennzeichnet, dass** die Taktentnahmeschaltung ferner eine Schaltung umfasst, den so genannten Synchronisationsimpulsgenerator (20), der ein Stromimpulssignal auf der Flankenfrequenz des empfangenen Signals generiert und an den Betrieb des einspeisungsgekoppelten Oszillators (19) angepasst ist, wobei dieser Synchronisationsimpulsgenerator (20) geeignet ist, um das Stromimpulssignal an einem einzigen Ausgang 22 abzugeben, der nur mit einem Stromeingang (23) des einspeisungsgekoppelten Oszillators (19) verbunden ist.

13. Vorrichtung nach einem der Ansprüche 1 bis 12, zum Entnehmen eines Taktes und von digitalen Daten, ferner umfassend eine Schaltung (15) zum Abtasten des empfangenen Signals mit dem Empfangstaktsignal, wobei diese Abtastschaltung (15) einen ersten Eingang, den so genannten Signaleingang (17), der mit dem Empfangseingang verbunden ist, und einen zweiten Eingang, dem so genannten Takteingang (18), der mit einem Taktausgang (29) des einspeisungsgekoppelten Oszillators verbunden ist, umfasst, wobei diese Abtastungsschaltung 15 geeignet ist, um an mindestens einem Datenausgang (16) digitale Daten abzugeben, die durch das empfangene Signal übertragen werden,
**dadurch gekennzeichnet, dass** es mindestens eine Phasenverschiebungsschaltung (37a, 37b, 37c, 37d, 37e, 37f) umfasst, die geeignet ist, um eine konstante Phasendifferenz zwischen dem Signaleingang (17) und dem Takteingang (18) der Abtastschaltung (15) einzuführen, wobei sich die Gesamtphasendifferenz zwischen diesen beiden Eingängen (17, 18) daraus ergibt, dass jede Phasenverschiebungsschaltung geeignet ist, um eine Phasenausrichtung des Signals am Signaleingang (17) und des Signals am Takteingang (18) zu gewährleisten.

14. Vorrichtung nach einem der Ansprüche 1 bis 13, **dadurch gekennzeichnet, dass** es geeignet ist, um auf einer Bittaktfrequenz fsr von mehr als 500 MHz funktionieren zu können.

## Claims

1. Device for clock extraction from a baseband serial signal, known as the received signal, that is representative of digital data and coded with a clock signal exhibiting a clock-bit frequency fsr, including:
- a circuit (19) receiving a signal resulting from the received signal and clocked at the clock-bit frequency fsr and supplying, to at least one clock output (29), a clock signal, known as the reception clock signal, at least substantially synchronised and in phase with the clock-bit frequency fsr of the received signal,
- a phase-control loop (25) including:
- a first input (27) connected to a clock output (29) of the circuit (19) supplying a reception clock signal,
- a second input (28) which is fed by a signal resulting from the received signal,
- a digital phase detector (26) including a lead/lag detector connected to the first and second inputs (27, 28) and adapted to supply to at least one output (33a, 33b) at least one digital signal, known as the phase-state signal, that is representative of a phase shift between the reception clock signal and the received signal, and of the direction of this shift,
- an output (36a) supplying a signal, known as the control signal, connected to an input, known as the command input, of the circuit (19) supplying a reception clock signal, which is adapted so that the value of the frequency of the reception clock signal depends on the value of the control signal received at this control input,
- a circuit, known as the counting circuit (30, 35, 55, 91, 92, 116, 117), exhibiting an input connected to said output (33a, 33b) of the digital phase detector (26), said counting circuit being adapted to implement at least one filtering by digital counting/down-counting in respect of the variations of the relative values of the digital signal which are supplied in time by the phase detector (26), and to supply a control signal in digital form, the value of which is a function of the result of this filtering or these filterings, this value of the control signal being adapted to set a value of the frequency of the reception clock signal equal to a value, filtered in this way, of the clock-bit frequency fsr of the reception clock signal,
**characterised in that**:
- the circuit (19) supplying a reception clock signal is an injection-locked oscillator (19) with digital control, including a digital control input which is adapted to be able to receive the control signal supplied by the phase-control loop (25) in digital form, and so that the value of the natural frequency fos of the oscillator (19) depends on the value of the control signal received at this control input,
- the phase-control loop (25) includes a circuit (30) exhibiting at least one input (32a, 32b) connected respectively to the output or the outputs of the lead/lag detector (26) and supplying to at least one output (31a, 31b) a digital signal, known as the filtered phase-state signal:
- having a first relative value after reception of a predetermined number N greater than 1 of successive identical values at the input, corresponding to N successive data bits of the received signal for which the lead/lag detector (26) has detected a phase shift in the same direction,
- having a second relative value after reception of N successive identical values at the input, corresponding to N successive data bits of the received signal for which the lead/lag detector (26) has detected a phase shift in the other direction,
- having a third relative value in the other cases, so that the relative value of the filtered phase-state signal is representative of the presence of a phase shift in the same direction and of the direction of this phase shift, for N successive data bits of the received signal, between the edges of the reception clock signal and the corresponding data bits of the received signal.

2. Device according to Claim 1, **characterised in that** the lead/lag detector (26) is adapted to supply to a first output (33a) a digital signal (E) that is representative of the presence of a phase lead between the reception clock signal and the received signal, and to a second output (33b) a digital signal (L) that is representative of the presence of a phase lag between the reception clock signal and the received signal.

3. Device according to one of Claims 1 or 2, **characterised in that** the lead/lag detector (26) is adapted to sample the received signal at the rising and falling edges of the reception clock signal.

4. Device according to one of Claims 1 to 3, **characterised in that** the lead/lag detector (26) is adapted to implement a double sampling, one in phase with the edges of the reception clock signal, the other in quadrature with the edges of the reception clock signal, in such a manner as to determine the intermediate state of the received signal.

5. Device according to one of Claims 1 to 4, **characterised in that** said circuit (30) supplying the filtered phase-state signal is a decision-making converter (30).

6. Device according to one of Claims 1 to 5, **characterised in that** said counting circuit includes at least one circuit, known as the accumulator circuit (35, 55, 91, 92, 116, 117), including at least one input (32a, 32b) receiving a digital signal resulting from each phase-state signal supplied by the lead/lag detector (26), this accumulator circuit being adapted to supply a digital signal, known as the counting/down-counting signal, the relative value of which is representative of the reception of a plurality of relative values exhibited at the input or the inputs (32a, 32b) of this accumulator circuit.

7. Device according to Claim 6, **characterised in that** said counting circuit includes successively a decision-making converter (30) and an accumulator circuit (35, 91, 92) which is adapted to aggregate the relative values of the filtered phase-state signal supplied by the decision-making converter (30).

8. Device according to Claim 7, **characterised in that** the accumulator circuit exhibits a parallel output (36) and is adapted to supply to this parallel output (36) a parallel digital counting/down-counting signal, and **characterised in that** the injection-locked oscillator (19) includes a parallel digital control input including a number of bits lower than that of the parallel digital output (36) of the accumulator circuit, only a portion (36a) of the high-weight bits of the parallel digital output (36) of the accumulator circuit being linked to the bits of the parallel digital control input of the injection-locked oscillator (19), so that said control signal supplied by the counting circuit is formed from said portion (36a) of the high-weight bits of said counting/down-counting signal.

9. Device according to Claim 8, **characterised in that** the parallel digital input of the injection-locked oscillator (19) comprises 5 bits, only the 5 high-weight bits of the parallel digital output (36) of the accumulator circuit being linked to the 5 bits of the parallel digital control input of the injection-locked oscillator.

10. Device according to one of Claims 1 to 9, **characterised in that** the digital control input of the injection-locked oscillator (19) is connected to a circuit including a plurality of switches (45a, 45b, 45c, 45d, 45e), each switch being connected in series to at least one condenser integrated into the circuit of the oscillator (19) in such a manner as to modify its natural frequency.

11. Device according to Claims 7 and 10, **characterised in that** each bit of the digital control input is linked to one of the switches.

12. Device according to one of Claims 1 to 11, **characterised in that** the clock-extraction circuit includes, in addition, a circuit, known as the synchronisation-pulse generator (20), generating a signal of current pulses at the frequency of edges of the received signal and adapted for the operation of the injection-locked oscillator (19), this synchronisation-pulse generator (20) being adapted to supply the current-pulse signal to a single output (22) connected solely to a current input (23) of the injection-locked oscillator (19).

13. Device according to one of Claims 1 to 12, for clock extraction and for extraction of digital data, including, in addition, a circuit (15) for sampling of the received signal with the reception clock signal, this sampling circuit (15) having a first input, known as the signal input (17), connected to the reception input, and a second input, known as the clock input (18), connected to the clock output (29) of the injection-locked oscillator, this sampling circuit (15) being adapted to supply to at least one data output (16) digital data transmitted by received signal,
**Characterised in that** said device includes at least one phase-shifting circuit (37a, 37b, 37c, 37d, 37e, 37f) which is adapted to introduce a constant phase difference between the signal input (17) and the clock input (18) of the sampling circuit (15), the total phase difference between these two inputs (17, 18) resulting from each phase-shifting circuit being adapted to guarantee a phase alignment of the signal at the signal input (17) and of the signal at the clock input (18).

14. Device according to one of Claims 1 to 13, **characterised in that** said device is adapted to be able to function with a clock-bit frequency fsr higher than 500 MHz.
